(19) Europäisches Patentamt
European Patent Office
Office européen des brevets

(11) **EP 3 899 562 B1**

(12) **FASCICULE DE BREVET EUROPEEN**

(45) Date de publication et mention de la délivrance du brevet:
**15.05.2024 Bulletin 2024/20**

(21) Numéro de dépôt: **19845591.7**

(22) Date de dépôt: **15.12.2019**

(51) Classification Internationale des Brevets (IPC):
**G01R 31/382** (2019.01)  **G01B 21/32** (2006.01)
**G01R 31/392** (2019.01)

(52) Classification Coopérative des Brevets (CPC):
**G01R 31/392; G01B 21/32; G01R 31/382;**
Y02E 60/10

(86) Numéro de dépôt international:
**PCT/FR2019/053072**

(87) Numéro de publication internationale:
**WO 2020/128263 (25.06.2020 Gazette 2020/26)**

(54) **ESTIMATION DU SOH ET ESTIMATION DU SOC D'UN ELEMENT ELECTROCHIMIQUE**

SCHÄTZUNG DER SOH UND SCHÄTZUNG DES SOC EINES ELEKTROCHEMISCHEN ELEMENTS

ESTIMATING THE SOH AND ESTIMATING THE SOC OF AN ELECTROCHEMICAL ELEMENT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.12.2018 FR 1873112**

(43) Date de publication de la demande:
**27.10.2021 Bulletin 2021/43**

(73) Titulaire: **SAFT**
**92300 Levallois-Perret (FR)**

(72) Inventeurs:
• **LAURENT, Sébastien**
  **33700 Mérignac (FR)**
• **BARRAILH, Gérard**
  **64360 Monein (FR)**
• **LEGRAND, Nathalie**
  **33520 Bruges (FR)**
• **BUISSON, Emilie**
  **86000 POITIERS (FR)**
• **DIDELON, Rémi**
  **86700 PAYRE (FR)**

(74) Mandataire: **Bandpay & Greuter**
**11 rue Christophe Colomb**
**75008 Paris (FR)**

(56) Documents cités:
WO-A1-2017/087807    WO-A2-2011/072295
DE-A1-102012 208 509    DE-A1-102012 209 271
FR-A1- 2 991 510    US-A1- 2017 324 122

**Description**

**Domaine technique**

La présente invention concerne le domaine technique des méthodes, systèmes et programmes d'estimation de l'état de santé (SOH) et de l'état de charge (SOC) d'un élément électrochimique pour lequel une mesure de la tension ne permet pas d'estimer en permanence avec précision son état de charge.

**Technique antérieure**

Un générateur électrochimique ou accumulateur ou élément est un dispositif de production d'électricité dans lequel de l'énergie chimique est convertie en énergie électrique. L'énergie chimique est constituée par des composés électrochimiquement actifs disposés dans l'élément. L'énergie électrique est produite par des réactions électrochimiques au cours d'une décharge de l'élément. Les électrodes, disposées dans un contenant, sont connectées électriquement à des bornes de sortie de courant qui assurent une continuité électrique entre les électrodes et un consommateur électrique auquel l'élément est associé.

Typiquement, une batterie comprend une pluralité d'éléments susceptibles d'être regroupés au sein d'une même enceinte. Une batterie peut être divisée en modules, chaque module étant composé d'une pluralité d'éléments reliés entre eux en série et/ou en parallèle. La batterie est destinée à fournir de l'énergie électrique à une application extérieure. Un circuit de charge est généralement prévu auquel la batterie peut être branchée pour recharger les éléments. Un système de gestion comprenant des capteurs de mesures et un circuit électronique de contrôle, plus ou moins évolué selon les applications, peut être associé à la batterie.

Il est connu des standards de calcul de l'état de santé (SOH, acronyme anglais de « State Of Health ») d'un élément électrochimique, et par extension d'une batterie. Le SOH indique le degré de vieillissement de l'élément entre un état initial et un état à un instant donné. Le SOH d'un élément peut être calculé soit à partir du rapport de l'impédance de l'élément à un instant donné sur l'impédance de l'élément à l'état initial, soit à partir de l'estimation de la perte de capacité par comparaison avec la capacité de l'élément à l'état initial. Cependant, ces standards de calculs ne permettent pas de caractériser en ligne les causes du vieillissement de l'élément ; notamment la perte de capacité de la négative et la croissance de la couche de passivation (SEI, acronyme anglais de « solid-electrolyte interface ») d'un élément électrochimique au Lithium. Par exemple, des méthodes permettant d'estimer le SOH imposent une pleine charge ou décharge à des régimes restreints afin d'assurer une précision minimale. Ceci a pour conséquence d'imposer un cycle de maintenance, et de plus l'estimation de capacité ne fournit pas les causes du vieillissement.

Il est également connu des standards de calcul de l'état de charge (SOC, acronyme anglais de « State Of Charge ») d'un élément et par extension d'une batterie. Le SOC est la quantité d'énergie disponible dans la batterie rapportée à l'énergie d'une batterie totalement chargée. Typiquement il s'exprime en pourcentage et reflète la part d'énergie restante disponible pour l'utilisateur. Aujourd'hui, la plupart des standards de calcul du SOC sont basés sur une mesure continue des données tension-courant-température. Par exemple, on peut utiliser les deux modes de calculs suivants qui s'alternent successivement. Le mode principal est coulométrique, c'est-à-dire que l'état de charge dépend directement du comptage des Ampères-heures et de la capacité de la batterie. Or, ce mode est très sensible à l'erreur de mesure en courant ainsi qu'à l'estimation de la capacité. Des dérives en tension peuvent se produire si ce mode est utilisé seul. Le second mode est généralement basé sur la mesure en tension et utilise une table de l'état de charge en fonction de la tension en circuit ouvert. Mais ce second mode est sensible à l'estimation de la résistance, et une erreur d'estimation de résistance entraînera une erreur d'estimation de la tension en circuit ouvert (OCV, acronyme anglais de « Open Circuit Voltage ») et donc une erreur d'estimation du SOC.

Le document DE102012208509 concerne un dispositif pour déterminer une variable d'état d'une cellule pour convertir de l'énergie chimique en énergie électrique. Le dispositif comprend un capteur de force pour déterminer un changement de volume de la cellule afin de déterminer la variable d'état sur la base du changement de volume, et/ou un capteur de pression de gaz pour déterminer une pression de gaz interne de la cellule. Il est également connu des éléments dont la technologie est caractérisée par une courbe d'OCV fonction du SOC qui présente une pente faible car elle possède au moins une zone où la variation de l'OCV en fonction du SOC varie peu et/ou peut être non-univoque ; il est impossible d'associer une mesure de tension à un état de charge. La courbe d'OCV fonction du SOC peut être non-univoque, c'est-à-dire qu'il existe deux points de la courbe qui ont la même ordonnée mais une abscisse différente. Le document EP-A-2 269 954 décrit des exemples de tels éléments pour lesquels la variation de la tension à vide en fonction de l'état de charge présente une zone pour un état de charge compris entre environ 30 et environ 90% dans laquelle la tension à vide augmente au moins 10 fois moins rapidement en fonction de l'état de charge en moyenne que pour un état de charge compris entre 90% et 100%. De tels éléments sont connus sous le nom d'éléments électrochimiques à profil plat ou plus simplement éléments à profil plat. Le vieillissement induira des modifications de la relation entre l'OCV et le SOC.

Pour de tels éléments à profil plat, dans les zones où la croissance de la courbe d'OCV fonction du SOC est lente, il n'est pas possible de calibrer le SOC sur la tension, l'incertitude sur la mesure étant trop importante. Le calcul du SOC y est donc purement coulométrique. Cela implique qu'une capacité mal estimée (par exemple à cause du vieillissement de l'élément ou encore à cause d'une erreur sur la mesure de courant) peut rattraper l'écart de SOC lors d'une calibration sur la tension sur une partie de la courbe ayant une pente suffisante. Il est connu que l'information d'état de charge fournie est suffisamment précise pour une partie (appelée zone 4) de la courbe d'OCV fonction du SOC correspondant à un SOC compris aux alentours de 90 à 100%. Quand bien même la capacité serait bien estimée, l'erreur sur la mesure en courant limiterait le nombre de cycles autorisé sans calibration dans cette zone 4. Les méthodes actuelles de gestion de tels éléments comprennent de recaler l'information de SOC sur la tension sur la zone 4, à faible courant afin de minimiser l'incertitude de la valeur de la résistance. Cela peut imposer pour certaines application une pleine charge régulière, ce qui n'est notamment pas adapté pour des applications hybrides comme le ferroviaire ou les bus où la contrainte est journalière. Il est également possible de recaler en Zone 1 de la courbe d'OCV fonction du SOC ; la zone 1 correspond à un SOC compris aux alentours de 0 à 30%. Mais cela implique d'avoir connaissance de l'erreur commise sur le SOC par coulométrie proche de la fin de décharge.

Il n'existe donc pas actuellement de méthode susceptible d'être adaptée de manière satisfaisante à l'estimation de l'état de santé et de l'état de charge d'un élément électrochimique, et notamment lorsque l'élément électrochimique est un élément à profil plat.

## Résumé de l'invention

La présente invention propose pour cela un procédé d'estimation de l'état de santé (SOH) d'un élément électrochimique, comme défini par la revendication 1.

Un tel procédé améliore l'estimation du SOH d'un élément électrochimique car elle est indépendante de mesures électriques devant être effectuées directement ou indirectement aux bornes de l'élément électrochimique. En effet, l'estimation du SOH repose sur la détermination d'un signal qui est une image des déformations (mécaniques) subies par l'élément électrochimique pour une quantité d'électricité donnée l'ayant traversé au cours d'une opération de charge ou de décharge. Or, les déformations dépendent du vieillissement de l'élément électrochimique, c'est-à-dire que les valeurs mesurées caractérisent le vieillissement de l'élément. Ainsi, pour une même quantité d'électricité traversant un élément électrochimique, ce dernier aura des déformations différentes en fonction du vieillissement de l'élément électrochimique. La comparaison avec un signal image de référence de ce même élément électrochimique permet alors d'estimer le vieillissement de l'élément électrochimique.

Comme l'estimation du SOH est déterminée à partir des déformations de l'élément et est indépendante de régimes électriques particuliers qui s'appliqueraient à l'élément, l'estimation du SOH peut être effectuée quel que soit le courant sans perte de précision. De plus, l'estimation du SOH selon l'invention ne nécessite qu'une charge ou décharge partielle.

Selon différents modes de réalisation, toute combinaison d'au moins l'une des caractéristiques suivantes peut être implémentée :

- la comparaison comprend en outre le calcul d'une estimation de la capacité réelle de l'élément électrochimique $Capa_{batt}[N]$ à l'aide de la formule $Capa_{batt}[N] = Capa_{batt}[N-1] - (SEI\_Growth[N] + C_{neg\_loss}[N])$ où $Capa_{batt}[N-1]$ est une valeur de capacité de référence ;
- l'estimation de la croissance d'une couche de passivation (SEI) $SEI_{Growth}[N]$ est calculée par la formule $SEI\_Growth[N] = Ah_{PeakMin}[N-1] - Ah_{PeakMin}[N]$ où

$Ah_{PeakMin}[N-1]$ est une première valeur représentant une quantité d'électricité ayant traversé l'élément électrochimique pour une valeur minimale du signal image de référence, $Ah_{PeakMin}[N]$ est une deuxième valeur représentant une quantité d'électricité ayant traversé l'élément électrochimique pour une valeur minimale du signal image des déformations, et dans lequel l'estimation de la perte de capacité négative $C_{neg\_loss}[N]$ est calculée par la formule $C_{neg\_loss}[N] = (Ah_{PeakMax}[N-1] - Ah_{PeakMin}[N-1]) - (Ah_{PeakMax}[N] - Ah_{PeakMin}[N])$ où $Ah_{PeakMin}[N-1]$ est la première valeur représentant une quantité d'électricité ayant traversé l'élément électrochimique pour la valeur minimale du signal image de référence, $Ah_{PeakMin}[N]$ est la deuxième valeur représentant quantité d'électricité ayant traversé l'élément électrochimique pour la valeur minimale du signal image de référence, $Ah_{PeakMax}[N-1]$ est une troisième valeur représentant une quantité d'électricité ayant traversé l'élément électrochimique pour une valeur maximale du signal image de référence, $Ah_{PeakMax}[N]$ est une quatrième valeur représentant une quantité d'électricité ayant traversé l'élément électrochimique pour une valeur maximale du signal image des déformations ;

- le signal image de référence est obtenu suivant les mêmes étapes que le signal image calculé lors d'une précédente opération de charge ou de décharge ;

- la précédente opération de charge ou de décharge est la première opération de charge ou de décharge de l'élément électrochimique ;
- un calcul de la dérivée par rapport au temps du signal image de référence ;

et dans lequel la comparaison comprend la comparaison entre la dérivée calculée et une dérivée de référence.

La présente invention propose également un procédé d'estimation de l'état de charge (SOC) d'un élément électrochimique, comme défini par la revendication 7.

Un tel procédé améliore l'estimation du SOC d'un élément électrochimique car elle repose sur le procédé d'estimation du SOH précédemment décrit, c'est-à-dire que l'estimation du SOC est également indépendante de mesures électriques devant être effectuées directement ou indirectement aux bornes de l'élément électrochimique. Ainsi, tout comme pour l'estimation du SOH, l'estimation du SOC peut être effectuée quel que soit l'intensité du courant sans perte de précision, et elle peut être effectuée avec une charge ou décharge partielle de l'élément sans imposer un cycle de maintenance. De plus, en utilisant la mesure de déformation, le calcul du SOC est amélioré car une plage de valeurs du SOC en dehors de laquelle la calibration en circuit ouvert (OCV) est possible, est déterminée avec précision via des points de repères précis. Les éléments, ayant une courbe d'OCV fonction du SOC qui est non-univoque, voient la zone d'incertitude réduite. Par extension, cela permet un calcul précis du SOC hors des zones 1 et 4. Ainsi, le fonctionnel de l'élément est amélioré en s'affranchissant des contraintes de calibration du SOC sur la mesure en tension hors des zones plateaux pour les éléments avec des matériaux à transition de phase. Le procédé permet ainsi d'autoriser les cyclages de longue durée sur les zones plateaux sans dérives du SOC liées à l'erreur sur la mesure en courant. Le procédé permettant de recalibrer en ligne l'OCV, la précision du SOC est améliorée lors de calibration sur la mesure en tension.

Selon différents modes de réalisation, toute combinaison d'au moins l'une des caractéristiques suivantes peut être implémentée :

- la calibration de la tension en circuit ouvert (OCV) de l'élément électrochimique ;
- la calibration comprend en outre l'estimation du vieillissement de l'élément électrochimique par une estimation d'une croissante d'une couche de passivation (SEI) $SEI_{Growth}[N]$ et une estimation d'une perte de capacité négative $C_{neg\_loss}[N]$, et dans lequel la calibration de la tension en circuit ouvert (OCV) de l'élément électrochimique comprend la calibration de la tension en circuit ouvert (OCV) de l'électrode négative de l'élément électrochimique en réalisant le calcul d'une perte de matériau actif (LLI) et/ou d'une perte de lithium inventaire (LAM) correspondant(s) à l'estimation de la croissante de la couche de passivation (SEI) $SEI_{Growth}[N]$ et de l'estimation de perte de capacité négative $C_{neg\_loss}[N]$, la correction de la tension en circuit ouvert (OCV) de l'électrode négative en fonction du calcul de la perte de matériau actif (LLI) et/ou de la perte de lithium inventaire (LAM) ;
- la détermination d'une plage de valeurs comprend pour une opération de décharge de l'élément électrochimique le calcul de la valeur $SOC_{PeakMin}[N]$ par la formule $SOC_{PeakMin}[N] = 100 - 100 * (Ah_{PeakMin}[N] / Capa_{batt}[N])$ ; le calcul de la valeur $SOC_{PeakMax}[N]$ par la formule $SOC_{PeakMax}[N] = 100 - 100 * (Ah_{PeakMax}[N] / Capa_{batt}[N])$ et dans lequel la détermination d'une plage de valeurs comprend pour une opération de charge de l'élément électrochimique le calcul de la valeur minimale de la plage $SOC_{PeakMin}[N]$ par la formule $SOC_{PeakMin}[N] = 100 * (Ah_{PeakMin}[N] / Capa_{batt}[N])$ ; le calcul de la valeur maximale de la plage $SOC_{PeakMax}[N]$ par la formule $SOC_{PeakMax}[N] = 100 * (Ah_{PeakMax}[N] / Capa_{batt}[N])$, où $Ah_{PeakMin}[N]$ est la deuxième valeur représentant quantité d'électricité ayant traversé l'élément électrochimique pour la valeur minimale du signal image de référence ; $Ah_{PeakMax}[N]$ est une quatrième valeur représentant une quantité d'électricité ayant traversé l'élément électrochimique pour une valeur maximale du signal image des déformations ; et $Capa_{batt}[N]$ est une estimation de la capacité réelle de l'élément électrochimique ;
- l'estimation du vieillissement de l'élément électrochimique comprend une estimation d'une croissance d'une couche de passivation (SEI) $SEI_{Growth}[N]$ et une estimation d'une perte de capacité négative $C_{neg\_loss}[N]$, et dans lequel la comparaison comprend en outre le calcul d'une estimation de la capacité réelle de l'élément électrochimique $Capa_{batt}[N]$ à l'aide de la formule $Capa_{batt}[N] = Capa_{batt}[N-1] - (SEI_{Growth}[N] + C_{neg\_loss}[N])$ où $Capa_{batt}[N-1]$ est une valeur de capacité de référence, $SEI_{Growth}[N]$ est l'estimation de la croissance de la couche de passivation (SEI), $C_{neg\_loss}[N]$ est l'estimation de la perte de capacité négative.

La présente invention propose également un programme d'ordinateur, comme défini par la revendication 11, comprenant des instructions de code de programme pour l'exécution du procédé d'estimation de l'état de santé (SOH) et/ou d'estimation de l'état de charge (SOC) d'un élément électrochimique.

On propose aussi un support d'information lisible par un ordinateur, comme défini par la revendication 12, sur lequel est enregistré le programme d'ordinateur.

On propose en outre un système, comme défini par la revendication 13, comprenant un capteur de déformation de l'élément électrochimique, une unité de gestion de l'élément électrochimique, l'unité de gestion étant en communication avec le capteur et comprenant une unité de calcul couplée à une mémoire, la mémoire stockant le programme d'ordinateur et étant apte à stocker au moins des valeurs du signal image de référence, des valeurs du signal image calculé, et des valeurs de la comparaison.

Le système peut en outre comprendre le capteur de déformation est une jauge de contrainte qui délivre une tension formant le signal image des déformations en fonction de la quantité d'électricité traversant l'élément électrochimique dans le temps.

On propose aussi un ensemble comprenant le système et une batterie comprenant au moins un élément électrochimique couplé avec le capteur de déformation.

L'ensemble peut en outre comprendre que l'élément électrochimique est du type ayant une courbe d'état de charge (OCV) comprenant une zone plate dans laquelle la relation entre l'état de charge et/ou la tension en circuit ouvert (OCV) est non-bijective.

**Brève description des dessins**

Des modes de réalisation de l'invention vont être maintenant décrits au moyen d'exemples non-limitatifs de l'invention, et en référence aux figures, où :

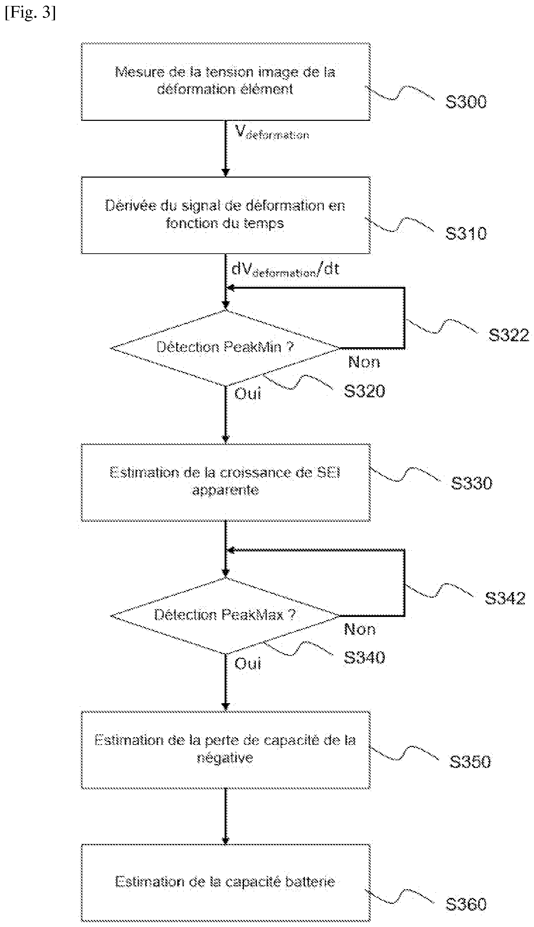

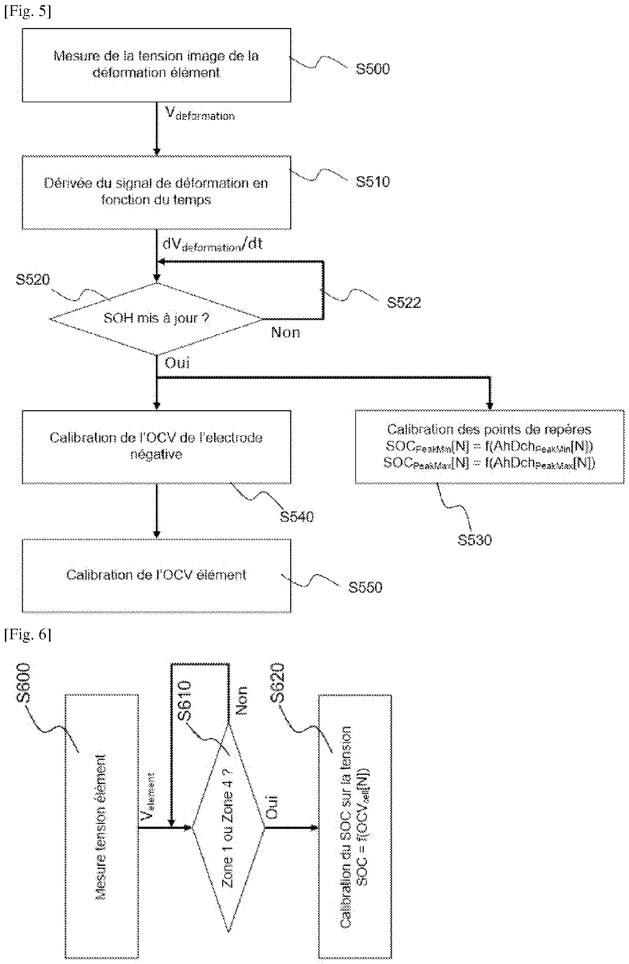

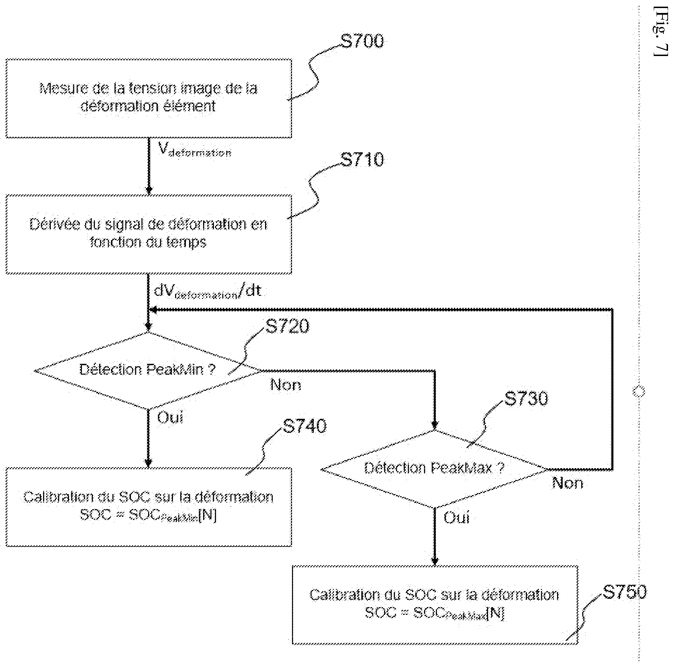

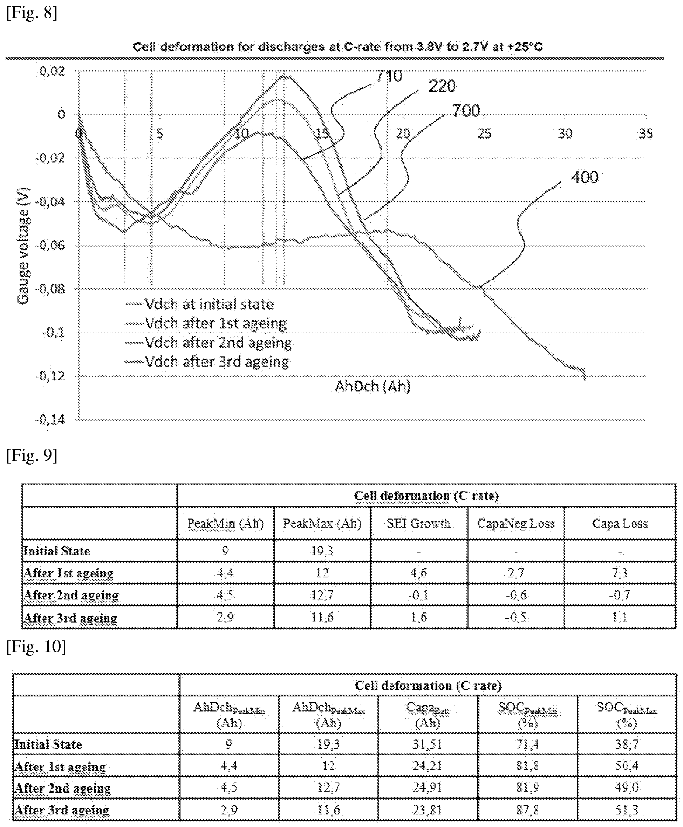

[fig.1]
est un exemple d'élément électrochimique dont la courbe d'OCV en fonction du SOC comprend une zone plate ;
[fig.2]
est un exemple de signal image des déformations d'un élément ;
[fig.3]
est un exemple d'algorigramme pour le calcul de l'estimation du SOH ;
[fig.4]
est un exemple illustrant des étapes de la Fig. 3 ;
[fig.5]
est un exemple d'algorigramme de calibrations des tables utilisées pour le calcul du SOC à partir des données de l'estimation du SOH ;
[fig.6]
est un exemple d'algorigramme dont l'utilisation conjointe avec celui de la Fig. 7 améliore la robustesse de l'estimation du SOC avec des recalibrations fréquentes ;
[fig.7]
est un exemple d'algorigramme dont l'utilisation conjointe avec celui de la Fig. 6 améliore la robustesse de l'estimation du SOC avec des recalibrations fréquentes ;
[fig.8]
est un exemple illustrant des étapes de la Fig. 3 ;
[fig.9]
est un exemple de valeurs calculées à partir des signaux images des déformations de la Fig. 8 pour estimer le SOH ;
[fig.10]
est un exemple de valeurs calculées à partir des signaux images des déformations de la Fig. 8 pour estimer le SOC ;
[fig.11]
est un exemple d'une représentation graphique de la détermination à partir des signaux images des déformations de la Fig. 8 de la plage de valeur du SOC en dehors de laquelle la calibration en circuit ouvert de l'élément est réalisable ;
[fig.12]
illustre un exemple de recalibration de la table OCV ;
[fig.13]
illustre un exemple de recalibration de la table OCV ;
[fig.14]
illustre un exemple de recalibration de la table OCV ;
[fig.15]
illustre un exemple de recalibration de la table OCV ;
[fig.16]
illustre un exemple de recalibration de la table OCV ;
[fig.17]
est un exemple de batterie ; et
[fig.18]
est un exemple de système pour estimer le SOH et/ou le SOC.

## EP 3 899 562 B1

**DESCRIPTION DE MODES DE REALISATION DE L'INVENTION**

La présente invention concerne l'estimation de l'état de santé (SOH) et de l'état de charge (SOC) d'un générateur électrochimique, aussi connu sous le terme d'accumulateur ou élément électrochimique ou encore élément. Ces termes désignent un dispositif de production d'électricité dans lequel de l'énergie chimique est convertie en énergie électrique et sont considérés comme synonymes par la suite.

On entend par tension en circuit ouvert (ou encore tension à vide) la tension mesurée aux bornes de l'élément lorsque celui-ci ne débite aucun courant (« Open circuit voltage » en anglais et également dénommé « tension en circuit ouvert » ; selon la définition 482-03-32 de la norme CEI 60050-482 :2004, Vocabulaire électrotechnique international partie 482 : piles et accumulateurs électriques).

On entend par courbe d'OCV en fonction du SOC, la variation de la tension en fonction de l'état de charge, dit plus simplement, la courbe d'OCV en fonction du SOC est une table qui met en relation des points de mesure d'OCV en fonction de valeurs de SOC.

La présente invention peut s'appliquer à un type particulier d'élément électrochimique dont la courbe d'OCV en fonction du SOC comprend soit une partie de courbe à faible pente, et/ou une partie de courbe à pente nulle, et/ou une partie de courbe qui n'est pas univoque. Ce type d'élément électrochimique est également connu sous l'expression « élément électrochimique à profil plat » ou plus simplement « élément à profil plat » ; le profil plat correspondant donc à la partie de courbe présentant la faible pente, et/ou la partie de courbe présentant la pente nulle, et/ou la partie de courbe qui n'est pas univoque. Plus généralement, un élément électrochimique à profil plat est un élément électrochimique dont au moins une partie de la variation de la tension OCV est comprise dans l'erreur de mesure du capteur servant à mesurer et/ou à estimer l'OCV, et/ou une partie de la courbe n'est pas univoque.

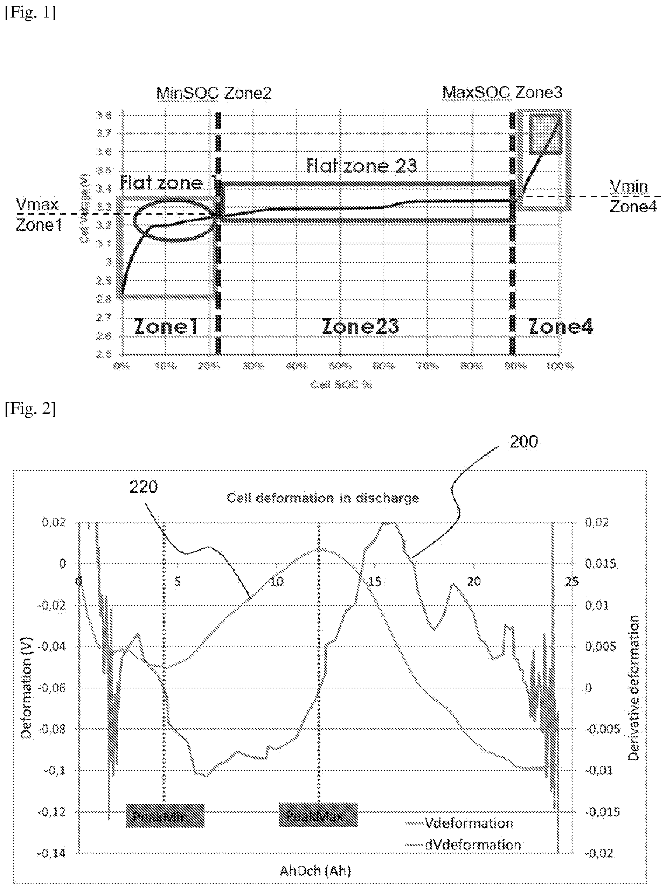

La FIG. 1 est un exemple schématique d'une courbe d'OCV fonction du SOC qui compte au moins un profil plat. Dans cet exemple, l'élément est un élément Lithium-ion dont une électrode positive comprend une matière électrochimiquement active de type phosphate lithié ou du type de celle décrite dans le document EP-A-2 269 954. Dans l'exemple de la FIG. 1, la courbe peut être divisée en quatre zones. La précision de mesure implique que les zones 2 et 3 sont confondues et forment un seul et même plateau ou zone plate (zone 23). La courbe d'OCV fonction du SOC de la zone 23 peut être non-univoque, c'est-à-dire qu'il existe deux points de la courbe qui ont la même ordonnée (une même valeur d'OCV) mais une abscisse différente (au moins deux valeurs de SOC différentes). La zone 1 dispose également d'un plateau, ce qui réduit fortement la zone pentue où une calibration sur la tension est possible. Le plateau de la zone 1 est la partie de la courbe qui est entourée sur la FIG. 1 ; en outre, cette zone 1 peut être la plus impactée par le vieillissement de l'élément. La zone 4 est la zone qui comprend une pente suffisante pour permettre une mesure précise de l'information de l'état de charge.

Les trois zones principales représentées sur la FIG. 1 sont maintenant discutées plus en détail. Zone 1 : elle correspond à une tension inférieure ou égale à VmaxZone1. A la valeur VmaxZone1 correspond un état de charge égal à MinSOCZone2. VmaxZone1 se situe en général entre 3 et 3,30V et vaut typiquement 3,30V. MinSOCZone2 se situe généralement dans la gamme allant de 15 à 30%, typiquement 30%. Dans la zone 1, la tension varie quasiment proportionnellement avec l'état de charge ; c'est-à-dire qu'à une tension donnée de l'élément correspond un état de charge donné. La zone 1 se subdivise encore en une première zone d'état de charge comprise entre 0 et moins de 10%, dans laquelle la tension de l'élément varie de plus 300 mV et une seconde zone d'état de charge comprise entre typiquement 10% et typiquement 30%, dans laquelle la tension varie moins vite en fonction de l'état de charge, par exemple d'environ 100 mV pour un accroissement d'état de charge de 20%. Cette seconde zone de charge est la partie de la courbe qui est entourée sur la FIG. 1.

Zone 23 : elle correspond à une tension supérieure à VmaxZone1 et inférieure à VminZone4. VminZone4 se situe en général entre 3,35 et 3,45V, et vaut typiquement 3,40V. A la valeur VminZone4 correspond un état de charge égal à MaxSOCZone3. MaxSOCZone3 se situe généralement dans la gamme allant de 80 à 95%, typiquement 90%. La zone 23 correspond typiquement à la zone de tensions comprises entre 3,30 V et 3,40 V correspondant à un état de charge compris typiquement entre 20% et typiquement 90 %. On peut noter une variation de tension de l'élément quasi nulle pour un état de charge compris entre 30% et 60% et pour un état de charge compris entre 65% et 90%. Dans la zone 23, la tension de l'élément varie peu, typiquement de l'ordre de 100 mV pour un état de charge compris entre environ 30 et environ 90%. Il en résulte une forte imprécision de l'état de charge dans la zone 23 puisqu'une valeur donnée de tension peut correspondre à un état de charge compris dans une large plage allant de 30 à 90%. La zone 23 se subdivise en deux sous-zones ; une première sous-zone : la zone 2 allant de MinSOCZone2 à MaxSOCZone2, soit de 22 à 60% et une seconde sous-zone, la zone 3 allant de MinSOCZone3 à MaxSOCZone3, soit de 65 à 90%. Les zones 2 et 3 se rejoignent vers un état de charge compris entre 60 et 65%.

Zone 4 : elle correspond à une tension supérieure ou égale à VminZone4. A la valeur VminZone4 correspond un état de charge égal à MaxSOCZone3. VminZone4 correspond à un état de charge d'environ 90%. Dans cette zone, la tension varie proportionnellement avec l'état de charge. Elle varie d'environ au moins 300 mV. A une tension donnée de l'élément correspond un état de charge donné.

L'exemple de la FIG. 1 n'est pas limitatif en ce sens qu'il n'illustre qu'un exemple d'élément à profil plat. De manière générale, un élément à profil plat est un élément électrochimique dont la matière active positive présente un profil de charge dans lequel la variation de la tension en fonction de l'état de charge entre un état de charge supérieur à MinSOCzone2 correspondant à une tension VmaxZone1 prédéterminée et un état de charge inférieur à MaxSOCzone3 correspondant à une tension VminZone4. La valeur de la tension OCV varie entre VmaxZone1 et VmaxZone2 et cette variation est comprise dans l'erreur de mesure d'un capteur de tension ; par exemple la précision du capteur n'est pas suffisante pour mesurer les variations d'OCV en zone 23.

Il est maintenant discuté des exemples d'estimation de l'état de santé (SOH) d'un élément électrochimique.

Dans une première étape, une opération de charge ou une opération de décharge de l'élément électrochimique est initiée. L'opération de charge ou de décharge qui a été initiée va être exécutée jusqu'à ce que les données permettant de produire une estimation du SOH soient obtenues. Une ou plusieurs estimations du SOH peuvent être produites durant une opération de charge ou de décharge.

Lors d'une opération de charge ou de décharge, une mesure de valeurs représent des déformations de l'élément électrochimique est réalisée (S300). Il est équivalent de dire que des mesures de valeurs des déformations de l'élément électrochimique sont réalisées. On entend par déformations de l'élément électrochimique des variations de dimension relative de l'élément électrochimique. La déformation d'un élément électrochimique se produisant pendant un cyclage électrochimique est un phénomène physique connu ; par exemple la déformation d'un élément lithium-ion.

Les valeurs des déformations mesurées forment un signal image des déformations en fonction de la quantité d'électricité traversant l'élément électrochimique dans le temps. En effet, les déformations sont mesurées pendant et pour une opération de charge ou bien une opération de décharge, cette opération étant réalisée sur une période de temps donnée. Ainsi, au fur et à mesure que l'opération de charge ou de décharge est réalisée, chaque valeur représent une variation de dimension relative de l'élément est mesurée en fonction d'une quantité d'électricité qui a traversé l'élément depuis que l'opération a été initiée. Alternativement, chaque valeur peut être mesurée en fonction de la quantité d'électricité qui a traversé l'élément depuis un premier point dans le temps autre que le commencement (l'initiation) de l'opération de charge ou de décharge.

Les mesures des déformations de l'élément électrochimique peuvent être effectuées avec tout capteur apte à détecter et à produire une valeur représent une déformation.

Dans des exemples, un capteur peut être un extensomètre du type extensomètre à fils résistants (encore connu sous le terme de déformation) qui traduit une déformation de l'élément électrochimique en une valeur de tension électrique. Un extensomètre à fils résistant permet de mesurer de faibles deformations.

Dans l'exemple de la FIG. 3, à l'étape S300, un signal image des déformations en fonction de la quantité d'électricité traversant l'élément électrochimique dans le temps est obtenu pendant une opération de décharge d'un élément électrochimique. Dans cet exemple, les déformations mesurées sont traduites en valeurs de tension en fonction du temps. Pendant que les déformations sont mesurées, la quantité d'électricité qui traverse l'élément électrochimique en fonction du temps est elle aussi mesurée. De ces deux mesures, c'est-à-dire les déformations dans le temps et la quantité d'électricité traversant l'élément dans le même temps, est obtenu (ou calculé) le signal image des déformations.

La FIG. 2 est une représentation graphique d'un signal image des déformations 200 d'un élément durant une opération de décharge. Dans cet exemple, le signal image des déformations est celui d'un élément électrochimique ayant une forme cylindrique, étant entendu que le procédé selon l'invention peut s'appliquer quel que soit le format de l'élément électrochimique. Les déformations mesurées sont traduites en valeurs de tension. Le signal image des déformations 200 évolue en fonction de la quantité d'électricité traversant l'élément pour une décharge à C. La quantité d'électricité est typiquement exprimée en ampères heure (Ah).

Après avoir obtenu le signal image des déformations, ce dernier est comparé avec un signal image de référence. La comparaison permet d'obtenir une ou plusieurs différences qui caractérisent une estimation du vieillissement de l'élément électrochimique. La comparaison entre les deux signaux peut utiliser, mais n'est pas limitée à, des méthodes de comparaisons qualitatives des deux signaux, des méthodes de calcul entre les valeurs des deux signaux. La une ou plusieurs différences obtenues - par exemple dans le comportement des courbes sur une plage de valeurs en abscisse, ou encore les valeurs obtenues par la comparaison des valeurs des deux courbes - représentent des modifications structurelles des constituants (électrodes, séparateur, ...) de l'élément électrochimique pour une quantité d'électricité donnée ayant traversé l'élément électrochimique. Ces modifications structurelles sont liées aux utilisations passées de l'élément, et sont donc indicatives de l'état de santé de l'élément électrochimique. En d'autres termes, l'évolution des déformations entre deux opérations identiques de charge ou de décharge est un indicateur, ou encore caractérise, le vieillissement d'un élément électrochimique.

La comparaison entre le signal image des déformation (formé à l'étape S300) et le signal image de référence est faite entre deux signaux images pour lesquels le même élément électrochimique a vu passer au maximum une quantité d'électricité identique ; « identique » peut signifier sensiblement la même, par exemple avec une différence comprise de préférence entre $\pm$ 5%, et pouvant aller jusqu'à $\pm$ 20%. La quantité d'électricité qui traverse l'élément pour obtenir le signal image des déformations et le signal image de référence permet d'obtenir pour un minimum local et un maximum de chacun des deux signaux images, la pleine charge et la pleine décharge ne constituant pas chacun de minimum et maximum locaux.

Dans des exemples, des conditions initiales similaires pour la formation des deux signaux images devant être comparés peuvent être fixées. Par exemple, les deux signaux images peut être obtenus à partir d'un même point de référence de charge, ce qui permet de faire la comparaison avec un signal image des déformations et un signal image de référence qui ont été obtenus pour un élément électrochimique dans des conditions électriques similaires, ce qui améliore sensiblement la précision de l'estimation du vieillissement de l'élément électrochimique.

Dans des exemples, le signal image de référence est obtenu suivant la même méthode que celle utilisée pour obtenir le signal image des déformations. Comme dit précédemment, le même élément électrochimique voit passer au maximum une quantité d'électricité identique pour la formation des deux signaux. Cette quantité d'électricité peut avoir traversé l'élément avec un même régime C/n, ou encore avec deux régimes respectifs. Si le signal image des déformations est obtenu pour une opération de décharge, le signal de référence aura été lui également obtenu pour une opération de décharge, et inversement.

La ou les différences obtenues par la comparaison permettent d'obtenir une image de l'évolution des modifications structurelles des constituants de l'élément entre deux opérations du même type, successives ou non. On comprend que les différences mesurées entre deux opérations successives peuvent permettre de détecter des évolutions sévères de l'élément, par exemple la détection d'un vieillissement prématuré ou anormal de l'élément.

Dans des exemples, le signal image de référence est obtenu pour une première ou une des premières opérations de charge ou de décharge de l'élément électrochimique. « Une des premières opérations » peut être une opération de charge ou de décharge par rapport à un état initial de l'élément électrochimique. L'état initial peut être celui d'un élément neuf, ou d'un élément déjà vieillit (c'est-à-dire usagé), ou d'un élément de seconde vie (c'est-à-dire pour une nouvelle utilisation). Dans tous les cas, l'état initial est une mise en utilisation de l'élément. Ainsi, le signal image de référence peut être obtenu lors de la première mise en utilisation ou de l'une des premières mises en utilisation de l'élément électrochimique.

Dans des exemples, la comparaison entre le signal image et le signal image de référence peut être réalisée en utilisant des dérivées par rapport au temps de chacun des deux signaux. Cela permet, si besoin est, de faciliter l'identification de valeurs particulières tels que les valeurs minimales et maximales de chacun des deux signaux. Cela permet également de faciliter le calcul de la comparaison. La FIG. 2 illustre ceci dans laquelle la dérivée 220 par rapport au temps du signal 200 est représentée. Les oscillations que connait le signal image (par exemple pour les parties gauches et droite du signal image 200) sont lissées, facilitant le calcul de la comparaison.

Dans l'exemple de la FIG. 3, à l'étape S310, la dérivée par rapport au temps est calculée après l'acquisition du signal image.

Dans des exemples, l'estimation du vieillissement de l'élément à partir de la une ou des plusieurs différences peut comprendre le calcul d'une estimation d'une croissance d'une couche de passivation (SEI) $SEI_{Growth}[N]$ et le calcul d'une estimation d'une perte de capacité négative $C_{neg\_loss}[N]$. La croissance de la SEI et la perte de capacité négative sont les deux principaux mécanismes physico-chimiques qui influencent le plus le vieillissement d'un élément électrochimique. Leur estimation à partir de la mesure de déformations de l'élément offre un moyen d'estimer avec précision le SOH de l'élément électrochimique.

Dans des exemples, le SOH est estimé à partir de l'estimation de la perte de capacité $Capa_{batt}[N]$ par comparaison avec la capacité de référence $Capa_{batt}[N-1]$ de l'élément. La capacité de référence $Capa_{batt}[N-1]$ de l'élément électrochimique peut être sa capacité à l'état initial, ou encore sa capacité après une des premières opérations de charge ou de décharge par rapport à un état initial, comme discuté précédemment. Dans ces exemples, une estimation de la capacité de l'élément électrochimique $Capa_{batt}[N]$ peut être calculée à l'aide de la formule (eq. 1) :

$$Capa_{batt}[N] = Capa_{batt}[N-1] - (SEI\_Growth\ [N] + C_{neg\_loss}[N]) \ (eq.\ 1)$$

où $Capa_{batt}[N-1]$ est une valeur de capacité de référence de l'élément. $Capa_{batt}[N]$ est aussi appelée capacité réelle de l'élément car elle estime l'énergie que peut stocker l'élément qui a vieilli.

En référence aux étapes S320 à S360 de la FIG. 3, il est maintenant discuté un exemple dans lequel le SOH est obtenu par un calcul de l'estimation de la capacité réelle de l'élément électrochimique selon la formule (eq. 1). Dans cet exemple, le calcul d'une estimation d'une croissance d'une couche de passivation (SEI) $SEI_{Growth}[N]$ et le calcul d'une estimation d'une perte de capacité négative $C_{neg\_loss}[N]$ sont réalisés. De plus, la comparaison entre le signal image et le signal image de référence est réalisée avec les dérivées par rapport au temps de ces deux signaux.

Les étapes S320 à S330 illustrent un exemple de calcul de l'estimation de la croissante de la couche de passivation (SEI), notée $SEI_{Growth}[N]$. A l'étape S320, une valeur nulle de la dérivée par rapport au temps du signal image des déformations est identifiée. Cette valeur nulle permet d'identifier un minimum local du signal image de déformation (S300). L'identification de cette valeur nulle de la dérivée est réalisée à l'aide de toute méthode mathématique connue. A ce minimum local correspond une valeur notée Ah$_{PeakMin}$[N] qui représente une quantité d'électricité ayant traversé l'élément électrochimique. Est exclus un minimum correspondant à l'élément électrochimique en pleine charge ou en pleine décharge. Ah$_{PeakMin}$[N] a pour dimension une unité de charge, typiquement des ampères heure (Ah). On comprendra que dans les exemples où l'étape S310 n'est pas réalisée, le minimum local est directement calculé à partir le signal image à l'aide de toute méthode connue.

Tant qu'une valeur minimale n'a pas pu être identifiée (S322), l'étape S320 est répétée. Cela peut être le cas par exemple lorsque la durée pendant laquelle l'opération de charge ou de décharge est réalisée, n'est pas suffisante pour obtenir un minimum, hors pleine charge et pleine décharge de l'élément électrochimique.

En même temps que l'étape S320-S322 est réalisée, ou encore avant qu'elle ne le soit, ou encore après qu'elle l'ait été, une valeur nulle de la dérivée par rapport au temps du signal image de référence est identifiée. Cette valeur nulle permet d'identifier un minimum local du signal image de référence. L'identification de cette valeur nulle de la dérivée par rapport au temps du signal image de référence peut être calculée avec la même méthode que pour le signal image des déformations. Est également exclus un minimum correspondant à l'élément électrochimique en pleine charge ou en pleine décharge. A ce minimum local correspond une valeur notée Ah$_{PeakMin}$[N-1] qui représente également une quantité d'électricité ayant traversé l'élément électrochimique et est de même dimension que Ah$_{PeakMin}$[N]. On comprendra que dans les exemples où l'étape S310 n'est pas réalisé, le minimum local est directement calculé sur le signal image de référence à l'aide de toute méthode connue.

Ensuite, à l'étape S330, SEI$_{Growth}$[N] est calculée par la formule (eq. 2)

$$ SEI\_Growth\ [N] = Ah_{PeakMin}[N\text{-}1] - Ah_{PeakMin}[N]\ (eq.\ 2) $$

où Ah$_{PeakMin}$[N-1] est une première valeur représentant la quantité d'électricité ayant traversé l'élément électrochimique pour une valeur nulle de la dérivée du signal image de référence, et Ah$_{PeakMin}$[N] est une deuxième valeur représentant la quantité d'électricité ayant traversé l'élément électrochimique pour une valeur nulle de la dérivée du signal image des déformations calculée à l'étape S310.

On comprendra que dans les exemples où l'étape S310 n'est pas réalisée, Ah$_{PeakMin}$ [N-1] est une première valeur représentant la quantité d'électricité ayant traversé l'élément électrochimique pour une valeur minimale locale du signal image de référence, et Ah$_{PeakMin}$[N] est une deuxième valeur représentant la quantité d'électricité ayant traversé l'élément électrochimique pour une valeur minimale locale du signal image des déformations calculé à l'étape S300.

Les étapes S340 à S350 illustrent un exemple de calcul de l'estimation de la perte de capacité négative, notée C$_{neg\_loss}$[N]. A l'étape S340, une deuxième valeur nulle de la dérivée par rapport au temps du signal image des déformations est identifiée. Cette valeur nulle permet d'identifier un maximum local du signal image de déformation (S300). Elle est calculée à l'aide de toute méthode mathématique connue. A ce maximum local correspond une valeur notée Ah$_{PeakMax}$[N] qui représente une quantité d'électricité ayant traversé l'élément électrochimique ; Ah$_{PeakMax}$[N] a pour dimension une unité de charge, typiquement des ampères heure (Ah).

Tant qu'une valeur maximale n'a pas pu être identifiée, l'étape S340 est répétée (S342). Cela peut être le cas par exemple lorsque la durée pendant laquelle l'opération de charge ou de décharge est réalisée n'est pas suffisante pour avoir obtenir un maximum, l'élément en pleine charge ou en pleine décharge ne constituant pas de minimum ou maximum local.

En même temps que l'étape S340-S342 est réalisée, ou encore avant qu'elle ne le soit, ou encore après qu'elle l'ait été, une deuxième valeur nulle de la dérivée par rapport au temps du signal image de référence est identifiée. Cette deuxième valeur nulle permet d'identifier un maximum local du signal image (S300). Est également exclus un maximum correspondant à l'élément électrochimique en pleine charge ou en pleine décharge. L'identification de cette valeur nulle de la dérivée peut être réalisée avec la même méthode que pour le signal image des déformations ou toute autre méthode. Le point de la courbe du signal image de référence pour lequel ce maximum local est atteint est noté Ah$_{PeakMax}$[N-1]. Ah$_{PeakMax}$[N-1] représente également une quantité d'électricité ayant traversé l'élément électrochimique et est de même dimension que Ah$_{PeakMax}$[N]. On comprendra que dans les exemples où l'étape S310 n'est pas réalisée, le maximum local est directement déterminé sur le signal image des déformations à l'aide de toute méthode connue.

Ensuite, à l'étape S350, C$_{neg\_loss}$[N] est calculée par la formule (eq. 3)

$$ C_{neg\_loss}[N] = (Ah_{PeakMax}[N\text{-}1] - Ah_{PeakMin}[N\text{-}1]) - (Ah_{PeakMax}[N] - Ah_{PeakMin}[N])\ (eq.\ 3) $$

où Ah$_{PeakMin}$[N-1] est une première valeur représentant la quantité d'électricité ayant traversé l'élément électrochimique pour une première valeur nulle de la dérivée du signal image de référence, et $Ah_{PeakMin}[N]$ est une deuxième valeur représentant la quantité d'électricité ayant traversé l'élément électrochimique pour une première valeur nulle de la dérivée du signal image des déformations, $Ah_{PeakMax}[N-1]$ est une troisième valeur représentant la quantité d'électricité traversant l'élément électrochimique pour une deuxième valeur nulle de la dérivée du signal image de référence, et $Ah_{PeakMax}[N]$ est une quatrième valeur représentant la quantité d'électricité traversant l'élément électrochimique pour une deuxième valeur nulle de la dérivée du signal image des déformations.

On comprendra que dans les exemples où l'étape S310 n'est pas réalisée, $Ah_{PeakMax}[N-1]$ est une troisième valeur représentant la quantité d'électricité ayant traversé l'élément électrochimique pour une valeur maximale locale du signal image de référence, et $Ah_{PeakMax}[N]$ est une quatrième valeur représentant la quantité d'électricité ayant traversé l'élément électrochimique pour une valeur maximale locale du signal image des déformations calculé à l'étape S300.

Sur la FIG. 3, le calcul de $C_{neg\_loss}[N]$ est réalisé après celui de $SEI_{Growth}[N]$. On comprendra qu'il est également possible de calculer $SEI_{Growth}[N]$ après $C_{neg\_loss}[N]$, voire en même temps.

Un minimum local et un maximum local respectivement du signal image et du signal image de référence sont donc identifiés. Dans des exemples, ils sont identifiés en recherchant deux valeurs nulles de la dérivée pour chacune des images, et dans d'autres exemples ils sont identifiés directement à partir des deux courbes. Le calcul de la $C_{neg\_loss}[N]$ réalisé avec eq.3 ne nécessite que l'identification du minimum et du maximum sur chacune des deux courbes des deux signaux. Ainsi, la mesure de valeurs représentant des déformations de l'élément électrochimique peut s'arrêter dès que le signal image des déformations comprend une valeur minimale et maximale, c'est-à-dire dès que deux valeurs nulles de la dérivée ont été identifiées, les états de pleine charge et de pleine décharge de l'élément ne constituant pas de minimum et maximum locaux. En outre, puisque la quantité d'électricité ayant traversé l'élément électrochimique pour obtenir le signal image de déformation et le signal image de référence est au maximum sensiblement la même, la valeur minimale et la valeur maximale du signal image des déformations peuvent être identifiées dès que cette quantité d'électricité a effectivement traversé l'élément pendant la mesure des déformations.

A l'étape S360, la capacité réelle de l'élément électrochimique est estimée à l'aide de la formule eq. 1. Ainsi, la comparaison entre la dérivée par rapport au temps du signal image et la dérivée par rapport au temps du signal image de référence, est obtenue pour deux points particuliers de chacune de ces deux courbes. Ce choix des minimum et maximum locaux de la dérivée du signal image et de la dérivée du signal image de référence facilite le calcul de la comparaison qui ne se fait que pour ces deux points particuliers. De plus, cette sélection de points particuliers permet de déterminer la $SEI_{Growth}[N]$ et la $C_{neg\_loss}[N]$ qui sont les deux principales causes du vieillissement d'un élément électrochimique, notamment pour les éléments électrochimiques qui présentent un profil plat, et donc les plus aptes pour caractériser le vieillissement de l'élément. Ainsi, les différences obtenues grâce à la comparaison des minima et maxima locaux du signal image et signal image de référence produisent une estimation du vieillissement de l'élément électrochimique.

$Capa_{batt}[N-1]$ est une valeur de capacité de référence. Cette valeur peut être la valeur théorique de la capacité de l'élément. Elle peut être la valeur de la capacité de l'élément initial, ou bien encore la capacité de l'élément presque initial. Elle peut également être calculée de la même manière que $Capa_{batt}[N]$ ; par exemple, $Capa_{batt}[N-1]$ est calculée à partir du signal image de référence. $Capa_{batt}[N]$ et $Capa_{batt}[N-1]$ sont de même dimension et ont pour dimension une unité de charge, typiquement des ampères heure (Ah).

Dans des exemples, $Capa_{batt}[N]$ peut être calculée en ne prenant en compte que $SEI_{Growth}[N]$ ou bien que $C_{neg\_loss}[N]$. Cela permet d'avoir une approximation de la capacité réelle de l'élément électrochimique.

La $SEI_{Growth}[N]$ ou la $C_{neg\_loss}[N]$ peuvent être estimées individuellement afin de connaitre l'état de dégradation de l'élément électrochimique.

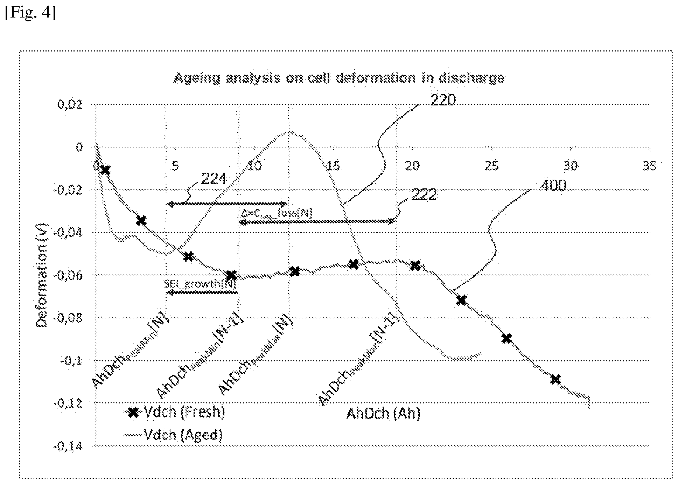

La FIG. 4 illustre l'exemple de la FIG. 3. La courbe 220 est la même que celle discutée en référence à la FIG. 2 et représente la déformation du signal image d'un élément électrochimique âgé ayant une forme cylindrique. La courbe 400 représente le signal image de ce même élément électrochimique à l'état initial, ou presque initial. La courbe 400 est donc dans cet exemple un signal image de référence avec lequel la courbe 220 est comparée. Le déplacement vers la gauche du minimum local $Ah_{PeakMin}[N]$ de la courbe 220 à comparer du minimum local $Ah_{PeakMin}[N-1]$ de la courbe 400 est un estimateur de la croissance de la SEI. La double flèche 222 illustre la partie de la courbe 400 correspondant à [N-1] - $Ah_{PeakMin}[N-1]$) et la double flèche 224 illustre la partie de la courbe 220 correspondant à ($Ah_{PeakMax}[N]$ - $Ah_{PeakMm}[N]$). L'estimation de la $C_{neg\_loss}$ est représentée par le recouvrement des deux doubles flèches 222 et 224.

La FIG. 8 est semblable à la FIG. 4, à l'exception qu'elle comporte deux courbes supplémentaires 700, 710, chacune représentant un signal image des déformations obtenus pour deux différents vieillissements de l'élément. La courbe 400 représente le signal image de référence. Par ordre croissant de vieillissement de l'élément électrochimique, la courbe 220 représente un premier signal image des déformations, la courbe 700 un deuxième et la courbe 710 un troisième signal image des déformations. On note qu'il exite généralement un décalage vers la gauche des valeurs minimales locales et maximales locales au fur et à mesure que l'élément vieillit.

La FIG. 9 est un tableau qui donne les valeurs $Ah_{PeakMax}[N]$ et $Ah_{PeakMin}[N]$ pour chacune des courbes représentées sur la FIG. 8. La première ligne correspond à la courbe 400, la deuxième à la courbe 220, la troisième à la courbe 700 et la dernière ligne à la courbe 710. Puisque la première ligne correspond à l'élément initial, les valeurs de SEI et de $C_{neg\_loss}$ ne sont pas applicables ; de même pour la dernière colonne du tableau qui représente la perte de capacité.

Les exemples portant sur l'estimation du SOH discutés jusqu'à présent peuvent être combinés entre eux.

En référence à la FIG. 5, il est maintenant discuté des exemples d'estimation du SOC d'un élément électrochimique qui utilise l'estimation du SOH selon l'invention. L'estimation du SOH est nécessaire pour déterminer avec précision l'état de charge de l'élément puisque chaque modification de la capacité réelle de l'élément influe directement sur l'estimation de l'état de charge. Ces exemples permettent notamment d'estimer le SOC lorsque l'élément électrochimique présente un profil plat (ou encore OCV plat).

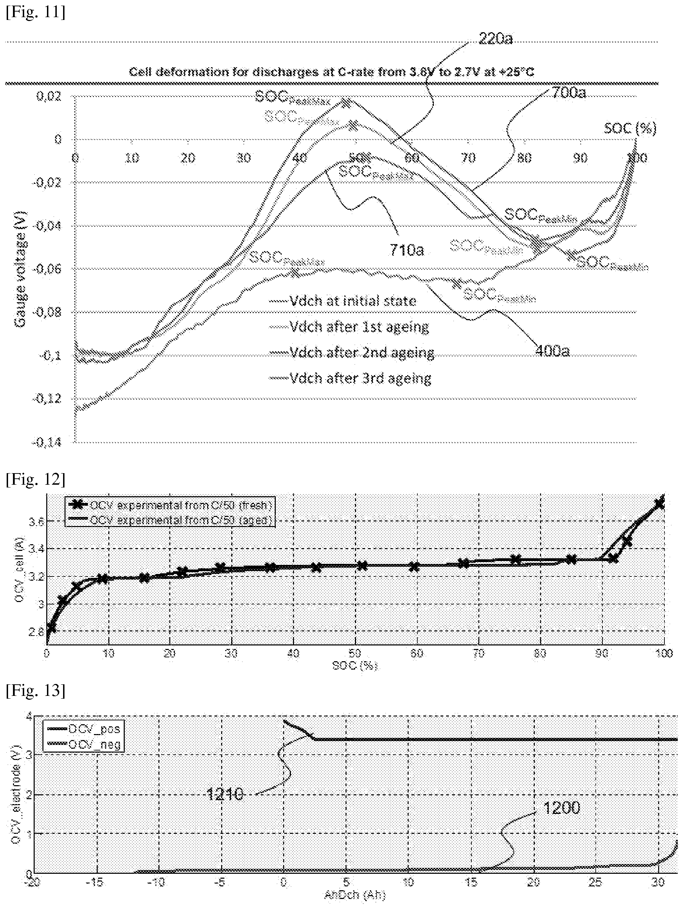

La FIG. 12 est une capture d'écran qui illustre la relation entre l'OCV et le SOC qui est notée SOC=f(OCV). Cette relation est typiquement contenue dans une table mettant en relation une valeur de SOC pour une tension OCV donnée. Comme le montre la FIG. 12, cette relation peut ne pas être bijective, c'est-à-dire qu'il n'y a pas une seule et unique valeur de SOC pour une OCV donnée. C'est par exemple le cas pour des valeurs de SOC comprises entre 40% et 60%. De plus, cette relation varie en fonction du vieillissement de l'élément, comme illustré sur la FIG. 12. Là encore, il peut ne pas y avoir une seule et unique valeur de SOC pour une OCV donnée. On peut en outre voir que ce sont les parties gauches et droites des courbes qui sont les plus impactées par ces modifications, or ces parties correspondent respectivement aux zones 1 et 4 discutées en référence avec la FIG. 1 et qui sont les seules pour lesquelles une calibration sur la mesure en tension est possible.

De retour sur FIG. 5, les étapes S500 et S510 sont semblables respectivement aux étapes S300 et S310 de la FIG. 3 dont des exemples ont été précédemment discutés. Plus généralement, l'un quelconque des exemples d'estimation du SOH précédemment discuté peut être réalisé.

Une fois que le SOH a été obtenu, il est déterminé une plage de valeurs du SOC en dehors de laquelle une calibration de la tension en circuit ouvert est réalisable. Dit autrement, une plage de valeurs du SOC actuel dans laquelle une calibration de la tension en circuit ouvert n'est pas réalisable.

L'étape S530 est un exemple de détermination de la plage de valeurs du SOC dans lequel des points particuliers sont déterminés. Cette plage de valeurs du SOC est donc bornée par deux valeurs particulières : une première valeur de la plage notée $SOC_{PeakMin}$ et une deuxième valeur de la plage notée $SOC_{PeakMax}$. Chacun de ces deux points peut être défini comme étant un point de repère ou un point de calibration sur une zone de l'élément où la calibration du SOC sur l'OCV n'est pas possible ; c'est typiquement le cas sur une zone plate d'élément à profil à plat.

$SOC_{PeakMin}$ est la valeur du SOC pour le minimum local du signal image des déformations, la pleine charge et la pleine décharge ne constituant pas de minimum local. On rappelle que $Ah_{PeakMin}[N]$ représente la quantité d'électricité ayant traversé l'élément électrochimique lorsque ce minimum local du signal image des déformations est atteint. Ainsi, $SOC_{PeakMin}$ est une première valeur représentant le SOC pour une valeur nulle de la dérivée du signal image de référence, ou selon le cas, pour une valeur minimale du signal image des déformations.

$SOC_{PeakMax}$ est la valeur du SOC pour le maximum local du signal image des déformations, la pleine charge et la pleine décharge ne constituant pas de minimum local. On rappelle que $Ah_{PeakMax}[N]$ représente la quantité d'électricité ayant traversé l'élément électrochimique lorsque ce maximum local du signal image des déformations est atteint. Ainsi, $SOC_{PeakMax}$ est une deuxième valeur représentant le SOC pour une valeur nulle de la dérivée du signal image de référence, ou selon le cas, pour une valeur maximale du signal image des déformations.

$SOC_{PeakMin}$ et $SOC_{PeakMax}$ représentent chacun une valeur actuelle du SOC, c'est-à-dire que ces deux valeurs sont fonction de $Capa_{batt}[N]$ qui est la capacité réelle de l'élément électrochimique et non pas une capacité théorique.

Dans des exemples pour lesquels une opération de décharge a été initiée, $SOC_{PeakMin}[N]$ est calculée avec la formule suivante :

$$SOC_{PeakMin}[N] = 100 - 100 * (Ah_{PeakMin}[N] / Capa_{batt}[N]) \text{ (eq. 4),}$$

et $SOC_{PeakMax}[N]$ est calculée par la formule suivante :

$$SOC_{PeakMax}[N] = 100 - 100 * (Ah_{PeakMax}[N] / Capa_{batt}[N]) \text{ (eq. 5).}$$

Dans des exemples pour lesquels une opération de charge a été initiée, $SOC_{PeakMin}[N]$ est calculée avec la formule (eq. 6)

$$SOC_{PeakMin}[N] = 100 * (Ah_{PeakMin}[N] / Capa_{batt}[N]) \ (eq.\ 6),$$

et $SOC_{PeakMax}[N]$ est calculée par la formule (eq. 7)

$$SOC_{PeakMax}[N] = 100 * (Ah_{PeakMax}[N] / Capa_{batt}[N]) \ (eq.\ 7)$$

Dans les formules eq. 4, eq. 5, eq. 6 et eq. 7, $Capa_{batt}[N]$ est une estimation de la capacité de l'élément électrochimique qui est obtenue suivant les exemples discutés pour l'estimation du SOH. Les valeurs $Ah_{PeakMin}[N]$ et $Ah_{PeakMax}[N]$ sont définies et obtenues comme expliqué en référence à la FIG. 3.

La FIG. 11 est un exemple de représentation des courbes des signaux images 400, 220, 700, 710 de la FIG. 8 qui sont maintenant représentées en fonction du SOC, respectivement 400a, 220a, 700a, 710a. S'agissant dans cet exemple d'une décharge de l'élément, la représentation des signaux image en fonction du SOC est calculée avec la formule suivante :

$$SOC\,[N] = 100 - 100 * (Ah\,[N] / Capa_{batt}[N]) \ (eq.\ 8)$$

Si une opération de charge était réalisée, alors la représentation des signaux image en fonction du SOC aurait été calculée avec la formule suivante :

$$SOC\,[N] = 100 * (Ah\,[N] / Capa_{batt}[N]) \ (eq.\ 9)$$

Les formules eq. 8 et eq. 9 sont des généralisations, respectivement des formules eq. 4/ 5 et eq. 6/7. Pour tout point Ah [N] du signal image, au moins une valeur de SOC (SOC [N]) est associée.

Chacune des représentations des signaux image de la FIG. 11 comprend : deux points de calibration $SOC_{PeakMin}$ et $SOC_{PeakMax}$ qui bornent une plage de valeurs de SOC actuelle (ou encore réelle) dans laquelle une calibration du SOC sur l'OCV n'est pas réalisable. On rappelle que dans les exemples des FIG. 8 et 11, l'élément électrochimique est le même élément à profil plat. On remarque que pour chacune des courbes, la plage comprise entre $SOC_{PeakMin}$ et $SOC_{PeakMax}$ est bien plus étroite à comparer de la zone 23 discutée en référence avec la FIG. 1. Ainsi, les deux points $SOC_{PeakMin}$ et $SOC_{PeakMax}$ permettent d'améliorer significativement le calcul de l'état de charge pour un élément électrochimique, et notamment pour un élément électrochimique à profil plat, en réduisant la zone d'incertitude en autorisant la calibration sur de larges plages d'état de charge. Dans cet exemple, la zone d'incertitude s'étend d'environ 50% à 85% du SOC, contre une zone d'incertitude comprise entre environ 30% à 90% du SOC comme discuté en référence avec la FIG. 1.

La FIG. 10 est un tableau qui reprend les valeurs $Ah_{PeakMax}[N]$ et $Ah_{PeakMin}[N]$ pour chacune des courbes représentées sur la FIG. 8, et qui présente les valeurs des points de calibration $SOC_{PeakMin}$ et $SOC_{PeakMax}$ représenté sur la FIG. 11. On notera que la première ligne correspond aux courbes 400 et 400a, la deuxième aux courbes 220 et 220a, la troisième aux courbes 700 et 700a, et la dernière ligne aux courbes 710 et 710a. La première ligne correspond à l'élément initial et une valeur de la capacité de référence $Capa_{batt}[N-1]$ est associée à l'élément initial.

Après le calcul des points de calibration $SOC_{PeakMin}$ et $SOC_{PeakMax}$, c'est-à-dire après la détermination de la plage de valeurs de SOC bornée par ces deux points, la calibration de la tension en circuit ouvert de l'élément électrochimique est réalisée. Cette calibration est faite en fonction de l'estimation du vieillissement de l'élément électrochimique : elle utilise le SOH de l'élément électrochimique, et donc la capacité réelle $Capa_{batt}[N]$, pour le calcul des points de calibration.

Aux étapes S540 et S550 de la FIG. 5, un exemple de calibration de l'OCV de l'élément électrochimique est présenté ; la calibration est réalisée sur l'électrode négative de l'élément électrochimique. En effet, l'OCV de l'élément électrochimique peut être définie par la formule suivante :

$$OCV = OCV_{pos} - OCV_{neg} \ (eq.\ 10)$$

où $OCV_{pos}$ est l'OCV de l'électrode positive de l'élément et $OCV_{neg}$ l'OCV de l'électrode négative de l'élément. Une modification liée au vieillissement de l'$OCV_{pos}$ et/ou de l'$OCV_{neg}$ agit donc sur l'OCV de l'élément.

La FIG. 13 présente deux tables d'OCV correspondant chacune à une électrode de l'élément. La courbe 1200 correspond à l'$OCV_{neg}$ de l'élément et la courbe 1210 à l'$OCV_{pos}$ de l'élément.

La FIG. 14 représente l'OCV de l'élément qui est la soustraction des deux courbes 1200 et 1210 de la FIG. 12.

A l'étape S540, la calibration de l'OCV de l'électrode négative est réalisée.

Dans des exemples, l'étape S540 est réalisée en fonction d'une estimation du vieillissement de l'électrode négative de l'élément électrochimique (S540).

L'estimation du vieillissement de l'électrode négative de l'élément électrochimique peut comprendre le calcul d'une estimation de la croissance de la couche de passivation (SEI) $SEI_{Growth}[N]$ et le calcul d'une estimation d'une perte de capacité négative $C_{neg\_loss}[N]$. Le calcul de ces deux estimations peut être réalisé comme expliqué en référence aux étape S320-S330 et S340 à S350 de la FIG. 3.

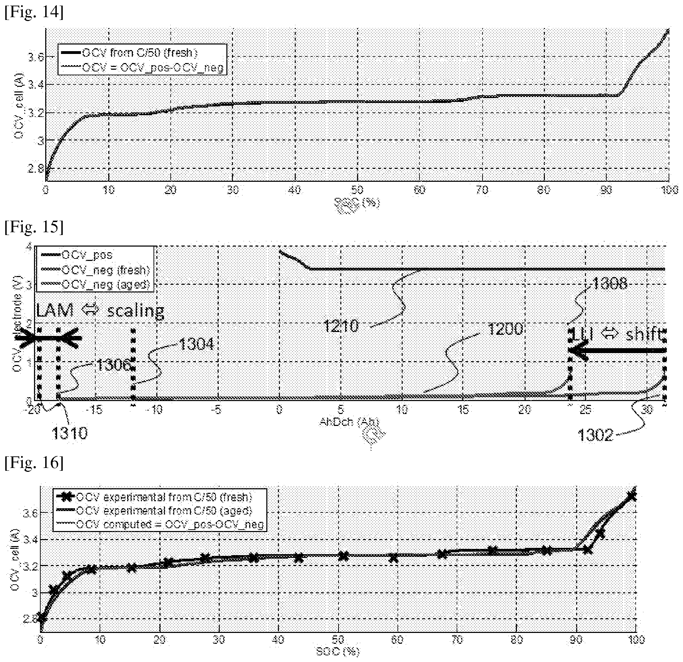

Dans un exemple où l'élément électrochimique est de type lithium, la perte de lithium actif (LLI, acronyme anglais de Loss of Lithium Inventory) et la perte de matériau actif (LAM, acronyme anglais de Loss of Active Material) est calculée à partir des estimations $SEI_{Growth}[N]$ et $C_{neg\_loss}[N]$. Les éléments électrochimiques de type lithium ont une technologie où le vieillissement par perte de capacité de la négative et croissance de SEI sont souvent prépondérants. La LLI est principalement liée à la SEI et la LAM est principalement liée à la $C_{neg\_loss}$. La perte de lithium actif (LLI) provoque un décalage horizontal des courbes de potentiel de l'électrode et la perte de matière active (LAM) engendre une compression des courbes de potentiel des électrodes de l'élément. Ce phénomène est illustré sur la FIG. 15 qui correspond à la FIG. 13 et sur laquelle les mêmes courbes 1200, 1210 sont représentées. Initialement, la courbe 1200 de l'OCV de l'électrode négative de l'élément a des valeurs comprises entre les points 1302 et 1304. Sous l'effet de la LLI, la courbe 1200 se décale vers la gauche, le point 1302 passant en position 1308 et le point 1304 en 1310. Dans le même temps, sous l'effet de la LAM, le point 1310 est repoussé en position 1306. La courbe 1200 est finalement décalée vers la gauche et compressée.

L'étape S540 comprend également la correction de la tension en circuit ouvert (OCV) de l'électrode négative en fonction du calcul de la perte de matériau actif (LLI) et/ou de la perte de lithium inventaire (LAM). La table d'OCV de l'électrode négative a été recalibrée en utilisant les résultats de l'analyse du vieillissement à partir de la mesure de déformation.

Ensuite, à l'étape S550, l'OCV de l'élément est corrigé à l'aide de la formule eq. 10, c'est-à-dire sur la base de l'OCV corrigée de l'électrode négative de l'élément.

La FIG. 16 est similaire à la FIG. 12, excepté que la FIG. 16 comprend une courbe supplémentaire qui représente la courbe OCV de l'élément électrochimique qui a été calculée à l'étape S550. Cette courbe calculée se confond avec la courbe expérimentale. On notera que l'OCV calculée est très proche de l'OCV expérimentale également en zones 1 et 4, ce qui améliore considérablement la précision du SOC.

Ainsi, le calcul du SOC pour des éléments électrochimiques est amélioré en permettant un calcul précis en zone 4 et en zone 1 en recalibrant l'OCV selon le vieillissement. En outre, comme cela a été précédemment discuté, la zone d'incertitude a été réduite de sorte qu'il est possible de recalibrer le SOC sur une partie de la zone 23.

De retour sur la FIG. 5, les étapes de calibration S530 à S550 peuvent être exécutées chaque fois qu'il est déterminé que le SOH a été mis à jour (S520). Lorsqu'aucune mise à jour n'est détectée, seules les étapes S500 et S510 continuent à être réalisées, par exemple pour calculer un nouveau SOH.

Le procédé de détermination du SOC selon l'invention peut être combiné avec des méthodes connues de détermination du SOC. Une telle combinaison est par exemple intéressante lorsque l'élément électrochimique est de type à profil à plat ou encore de type à transition de phase. Il est en effet possible d'utiliser un procédé connu pour les zones 1 et 4, et le procédé d'estimation du SOC selon l'invention pour les zones 2 et 3. Un tel procédé connu est discuté par exemple dans le document US2013229154 (A1).

Dans l'exemple de la FIG. 6, une mesure en tension (S600) de l'élément est réalisée. Lorsqu'il est déterminé (S610) que le SOC appartient à la zone 1 ou 4, une calibration du SOC sur l'OCV mesurée est réalisée en utilisant la relation SOC=f(OCV). Dans des exemples, tel que l'exemple discuté en référence avec la FIG. 1, des valeurs de SOC comprises en 0% et 20% sont comprises en zone 1, des valeurs comprises entre 20% et 90% sont comprises en zone 23, et des valeurs comprises entre 90% et 100% sont comprises en zone 4. On comprend que ces plages peuvent varier en fonction du type d'élément, et peuvent être déterminées de manière arbitraire.

Dans l'exemple de la FIG. 7, les étapes S700 et S710 produisent la dérivée d'un signal image. Ces étapes sont semblables respectivement aux étapes S300 et S310 de la FIG. 3. Ensuite si une valeur $Ah_{PeakMin}[N]$ est déterminée (S720), alors le SOC est calibré (S740) pour la valeur de SOC correspondant au minimum local du signal image de la déformation. L'étape S720 est semblable aux étapes S320 et l'étape S740 à l'étape S530. S'il n'est pas identifié une valeur $Ah_{PeakMin}[N]$ (S720), on essaie de déterminer s'il existe une valeur $Ah_{PeakMax}[N]$ à l'étape S730. Si ce n'est pas le cas, on repasse à l'étape S720. Si une valeur $Ah_{PeakMax}[N]$ a été identifiée à l'étape S730, alors le SOC est calibré (S750) pour la valeur de SOC correspondant au maximum local du signal image de la déformation. L'étape S730 est semblable à l'étape S340 de la FIG. 3 et l'étape S750 à l'étape S530. Les deux points $Ah_{PeakMin}[N]$ et $Ah_{PeakMax}[N]$ permettent de calibrer le SOC sur au moins une partie de la zone 23.

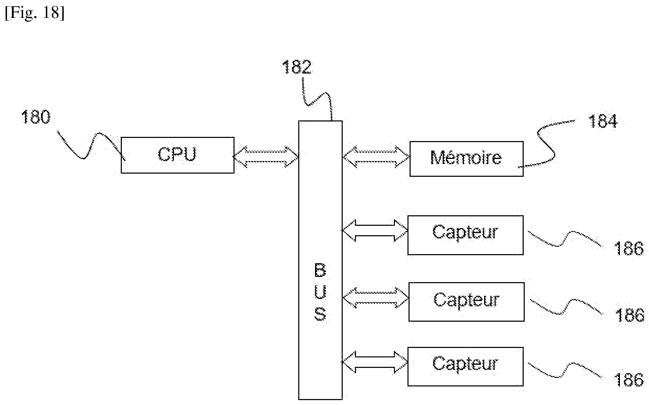

La FIG. 18 montre un exemple d'un système permettant d'estimer le SOH et/ou le SOC d'un élément électrochimique. Le système comprend une unité de gestion. L'unité de gestion comprend une unité de calcul (CPU) 180 qui est connectée à un bus 182 sur lequel est connectée une mémoire 184. La mémoire peut être une mémoire permettant de stocker les instructions et les données nécessaires au fonctionnement d'un programme d'ordinateur. La mémoire peut être, mais n'est pas limitée à, une mémoire non volatile, incluant par exemple des mémoires semi-conducteurs tels que des EPROM, EEPROM, mémoire flash, des disques magnétiques, des disques magnéto-optiques, des CD-ROM, DVD-ROM, disques BlueRay©. Tous ces éléments peuvent être suppléés par ou incorporés dans, des ASICs (acronyme anglais de « application-specific integrated circuits »). L'unité de gestion peut permettre à des capteurs 186 de déformation de communiquer avec la mémoire et l'unité de calcul via le BUS 182. Ces capteurs de déformation peuvent être disposés sur un ou plusieurs éléments électrochimiques.

Le programme d'ordinateur peut comprendre des instructions exécutables par l'unité de gestion. Les instructions comprennent des moyens pour amener le système à exécuter le procédé selon l'invention. Le programme peut être enregistrable sur n'importe quel support de stockage de données, y compris la mémoire de l'unité de gestion. Le programme peut, par exemple, être mis en oeuvre dans des circuits électroniques numériques, ou dans du matériel informatique, des micrologiciels, des logiciels ou des combinaisons de ceux-ci. Le programme peut être mis en oeuvre sous la forme d'un appareil, par exemple un produit incorporé de manière tangible dans un dispositif de stockage lisible par machine pour une exécution par un processeur programmable. Les étapes du procédé peuvent être exécutées par un processeur programmable exécutant un programme d'instructions pour exécuter des fonctions du procédé en opérant sur des données d'entrée et en générant une sortie. Le processeur peut ainsi être programmé et couplé pour recevoir des données et des instructions, pour transmettre des données et des instructions à un système de stockage de données, à au moins un dispositif d'entrée et à au moins un dispositif de sortie. Le programme d'ordinateur peut être implémenté dans un langage de programmation procédural ou orienté objet de haut niveau, ou en langage assembleur ou machine si nécessaire. Dans tous les cas, le langage peut être un langage compilé ou interprété. Le programme peut être un programme d'installation complet ou un programme de mise à jour. L'application du programme sur le système entraîne dans tous les cas des instructions pour l'exécution de la méthode.

Le programme et le système peuvent uniquement donner une estimation du SOH, ou encore uniquement donner une estimation du SOC, ou donner une estimation du SOH et du SOC. On comprend que lorsqu'une estimation du SOC est réalisée, le programme réalise une estimation du SOH au préalable.

La mémoire du système de la FIG. 18 stocke le programme d'ordinateur qui comprend les instructions de code de programme pour l'exécution du procédé d'estimation du SOH et/ou du SOC selon l'invention. La mémoire est en plus apte à stocker au moins des valeurs du signal image de référence. Ces valeurs sont typiquement $Ah_{PeakMin}[N-1]$ et $Ah_{PeakMax}[N-1]$, et la quantité d'électricité qui a traversée l'élément électrochimique lorsque le signal image de référence a été établi. Ces valeurs peuvent en outre comprendre $SOC_{PeakMin}[N-1]$ et $SOC_{PeakMax}[N-1]$. La mémoire peut en outre stocker des valeurs du signal image calculé, et des valeurs de la comparaison. La mémoire peut en outre stocker un signal image de référence et/ou la dérivée de ce signal image de référence. La mémoire peut également stocker une ou plusieurs valeurs de capacité de référence $Capa_{batt}[N-1]$.

Dans des exemples, le capteur de déformation est une jauge de contrainte qui délivre une tension image de la déformation en temporel ou temps réel. Le signal image de la déformation est formé en fonction de la quantité d'électricité traversant l'élément électrochimique dans le temps car la quantité d'électricité qui traverse l'élément électrochimique est mesurée en temps réel. Le lien entre la tension image de la déformation en temps réel et la quantité d'électricité traversant l'élément électrochimique dans le temps est immédiat. Plus généralement, les mesures des déformations de l'élément électrochimique peuvent être effectuées avec tout capteur apte à détecter et à produire une valeur représentant une déformation.

Dans les exemples des FIG. 2, 4, 8 à 11, l'élément électrochimique a une forme cylindrique (par exemple une batterie cylindrique) et le capteur utilisé est une jauge de contrainte qui est disposée sur la surface de l'élément selon une direction sensiblement perpendiculaire à l'axe du cylindre ; la jauge est donc disposée de façon à ce qu'elle puisse mesurer une déformation du diamètre du cylindre. Toujours dans ces exemples, la jauge de contrainte est également disposée sensiblement au milieu du cylindre - c'est-à-dire que la distance séparant le capteur de chacune des deux extrémités du cylindre est sensiblement la même -. Une telle disposition du capteur par rapport à un élément cylindrique permet de mesurer les déformations dans une zone où les déformations sont les plus importantes ; cela permet d'employer par exemple un capteur moins sensible ou ayant une erreur de mesure plus importante. On comprendra que la disposition du capteur n'est pas limitée à cet exemple. De manière générale, toutes les configurations peuvent être envisagées si une déformation de l'élément peut être mesuré. Les différentes dispositions peuvent dépendre par exemple de la forme de l'élément électrochimique, du type de capteur (sensibilité, erreur de mesure, mesure pouvant être faite selon une, ou deux ou plus directions...).

Dans un exemple, un ensemble comprend le système permettant d'estimer le SOH et/ ou le SOC d'un élément électrochimique et un élément électrochimique. L'élément électrochimique comprend un capteur qui va mesurer des valeurs de déformations sur l'élément. L'ensemble peut comprendre une batterie constituée d'un ou plusieurs éléments électrochimiques. Une batterie comprend une pluralité d'éléments susceptibles d'être regroupés au sein d'une même enceinte. Une batterie peut être divisée en modules, chaque module étant composé d'une pluralité d'éléments reliés entre eux en série et/ou en parallèle. La batterie est destinée à fournir de l'énergie électrique à une application extérieure. Un circuit de charge est généralement prévu auquel la batterie peut être branchée pour recharger les éléments. Un système de gestion comprenant des capteurs de mesures et un circuit électronique de contrôle, plus ou moins évolué selon les applications, peut être associé à la batterie.

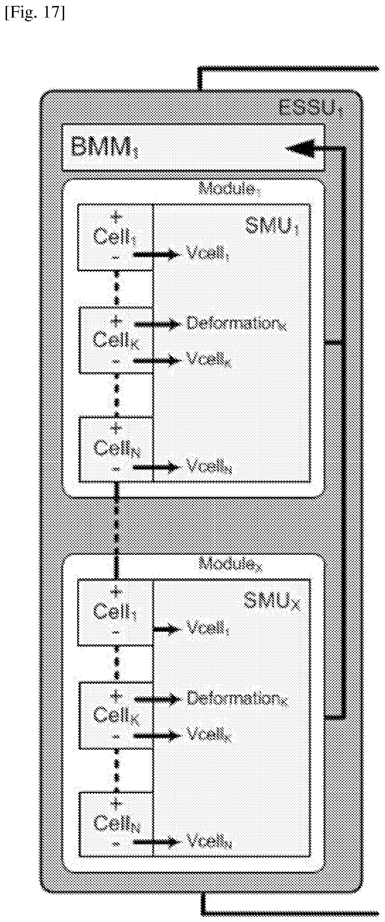

La FIG. 17 est un exemple de configuration d'une batterie dans laquelle N éléments électrochimiques (Cell1, Cell2,..., CellN) sont connectés en série et disposés ensemble dans une même enceinte pour former un premier module (Module 1). De manière similaire, N éléments électrochimiques sont connectés en série et disposés dans une xième enceinte pour former un xième module (Modulex). Les X modules sont connectés en série pour former une batterie (Bat). Les X modules constituent une branche du circuit. Les éléments ne sont pas non plus nécessairement connectés en série mais peuvent aussi être connectés en parallèle. Il est également envisageable de connecter certains éléments entre eux en parallèle pour obtenir plusieurs associations d'éléments en parallèle puis de connecter ces associations d'éléments en série. De même, la batterie peut comprendre un nombre quelconque de modules, dans une configuration non nécessairement limitée à une connexion en série. Par exemple, la batterie peut comprendre p branches parallèles, chaque branche parallèle comprenant au moins un élément ou au moins un module.

Chaque élément peut être muni d'un moyen de mesure de la tension à ses bornes. De préférence, un élément est aussi muni d'un moyen permettant de mesurer sa température de fonctionnement. Ce moyen de mesure est placé sur un point judicieusement choisi de l'élément afin d'avoir une représentation de sa température moyenne et/ou maximale et/ou minimale. Si la batterie comprend une pluralité d'éléments, chaque élément peut être muni d'un capteur de température mais cela rend plus complexe les circuits électroniques.

La batterie doit comprendre au moins un capteur de déformation. Le ou les capteurs de déformation peuvent être disposés sur des éléments, ou bien sur des modules. En pratique, un seul élément de la batterie comprend une jauge car une batterie comprend en principe des éléments identiques qui vieillissent et évoluent de manière semblable.

Le procédé d'évaluation du SOH et/ou du SOC selon l'invention s'applique à tout type d'élément électrochimique. Le procédé est notamment adapté aux éléments électrochimiques du type ayant une courbe de tension à vide (OCV) en fonction de l'état de charge (SOC) comprenant une zone plate, la relation entre l'état de charge et la tension en circuit ouvert (OCV) pouvant être non-bijective. Il est par exemple connu de tels éléments des documents EP-A-2 144 075, EP-A-2 239 826 et EP-A-2 309 615 dans lesquels on utilise comme matériau d'électrode positive d'un élément des phosphates lithiés d'au moins un métal de transition, notamment les composés de type $LiMPO_4$ où M est choisi dans le groupe comprenant Fe, Co, Ni, Mn et un mélange de ceux-ci.

De plus, le procédé selon l'invention peut s'appliquer à tout type d'élément électrochimique, indépendamment de son format. Dans des exemples non-limitatifs, l'élément électrochimique peut se présenter sous une forme cylindrique, prismatique, de bouton, de poche (aussi connu sous le nom anglais de « pouch »). Dans un exemple, un élément électrochimique de type « pouch » comprend au moins une cellule pouvant comprendre une plaque métallique intégrant une électrode positive, une électrode négative et un séparateur. Une telle cellule résulte de l'assemblage par juxtaposition d'un ensemble de composants se présentant sous la forme de feuilles souples réunies dans une enveloppe, et formant ainsi un élément de type « pouch ».

## Revendications

1. Procédé d'estimation de l'état de santé (SOH) d'un élément électrochimique, comprenant :

   - une initiation d'une opération de charge ou de décharge de l'élément électrochimique ;
   - une mesure de valeurs représentant des déformations de l'élément électrochimique pendant que l'opération de charge ou de décharge est réalisée, les valeurs de déformations mesurées formant un signal image des déformations en fonction de la quantité d'électricité traversant l'élément électrochimique dans le temps ;
   - une comparaison entre le signal image des déformations et un signal image de référence, une ou plusieurs différences obtenues par la comparaison caractérisant une estimation du vieillissement de l'élément électrochimique par une estimation d'une croissance d'une couche de passivation (SEI) SEIGrowth[N] et une estimation d'une perte de capacité négative $C_{neg\_loss}[N]$.

2. Procédé selon la revendication 1, dans lequel la comparaison comprend en outre :

   - le calcul d'une estimation de la capacité réelle de l'élément électrochimique $Capa_{batt}[N]$ à l'aide de la formule :

$$\text{Capa}_{\text{batt}}[N] = \text{Capa}_{\text{batt}}[N-1] - (\text{SEI\_Growth}[N] + C_{\text{neg\_loss}}[N])$$

où

$\text{Capa}_{\text{batt}}[N-1]$ est une valeur de capacité de référence.

3. Procédé selon l'une revendications 1 ou 2, dans lequel l'estimation de la croissance d'une couche de passivation (SEI) SEIGrowth[N] est calculée par la formule :

$$\text{SEI\_Growth}[N] = \text{Ah}_{\text{PeakMin}}[N-1] - \text{Ah}_{\text{PeakMin}}[N]$$

où

$\text{Ah}_{\text{PeakMin}}[N-1]$ est une première valeur représentant une quantité d'électricité ayant traversé l'élément électrochimique pour une valeur minimale du signal image de référence ;
$\text{Ah}_{\text{PeakMin}}[N]$ est une deuxième valeur représentant une quantité d'électricité ayant traversé l'élément électrochimique pour une valeur minimale du signal image des déformations ;
et dans lequel l'estimation de la perte de capacité négative Cneg_loss[N] est calculée par la formule :

$$\text{Cneg\_loss}[N] = (\text{Ah}_{\text{PeakMax}}[N-1] - \text{Ah}_{\text{Peak6Min}}[N-1]) - (\text{Ah}_{\text{PeakMax}}[N] - \text{Ah}_{\text{PeakMin}}[N])$$

où

AhPeakMin[N-1] est la première valeur représentant une quantité d'électricité ayant traversé l'élément électrochimique pour la valeur minimale du signal image de référence ;
AhPeakMin[N] est la deuxième valeur représentant quantité d'électricité ayant traversé l'élément électrochimique pour la valeur minimale du signal image de référence ;
AhPeakMax[N-1] est une troisième valeur représentant une quantité d'électricité ayant traversé l'élément électrochimique pour une valeur maximale du signal image de référence ;
AhPeakMax[N] est une quatrième valeur représentant une quantité d'électricité ayant traversé l'élément électrochimique pour une valeur maximale du signal image des déformations

4. Procédé selon l'une des revendications 1 à 3, dans lequel le signal image de référence est obtenu suivant les mêmes étapes que le signal image calculé lors d'une précédente opération de charge ou de décharge.

5. Procédé selon la revendication 4, dans lequel la précédente opération de charge ou de décharge est la première opération de charge ou de décharge de l'élément électrochimique.

6. Procédé selon l'une des revendications précédentes, comprenant en outre :

- un calcul de la dérivée par rapport au temps du signal image de référence ; et dans lequel la comparaison comprend :

- la comparaison entre la dérivée calculée et une dérivée de référence.

7. Procédé d'estimation de l'état de charge, SOC, d'un élément électrochimique, comprenant :

- une initiation d'une opération de charge ou de décharge de l'élément électrochimique ;
- une mesure de valeurs représentant des déformations de l'élément électrochimique pendant que l'opération de charge ou de décharge est réalisée, les valeurs de déformations mesurées formant un signal image des déformations en fonction de la quantité d'électricité traversant l'élément électrochimique dans le temps ;
- une comparaison entre le signal image des déformations et un signal image de référence, une ou plusieurs différences obtenues par la comparaison caractérisant une estimation du vieillissement de l'élément électrochimique ;
- une détermination d'une plage de valeurs de l'état de charge SOC bornée par une première valeur $\text{SOC}_{\text{PeakMin}}$ représentant le SOC actuel de l'élément pour une valeur minimale du signal image des déformations et une deuxième valeur $\text{SOC}_{\text{PeakMax}}$ représentant le SOC actuel de l'élément pour une valeur maximale du signal image des déformations, et en dehors de ladite plage la calibration de la tension en circuit ouvert (OCV) de l'élément électrochimique est réalisable.

8. Procédé selon la revendication 7, comprenant en outre l'étape consistant à :

   - la calibration de la tension en circuit ouvert (OCV) de l'élément électrochimique ;
   et dans lequel la calibration comprend en outre l'estimation du vieillissement de l'élément électrochimique par une estimation d'une croissante d'une couche de passivation (SEI) $SEI_{Growth}[N]$ et une estimation d'une perte de capacité négative $C_{neg\_loss}[N]$ ;

   et dans lequel la calibration de la tension en circuit ouvert (OCV) de l'élément électrochimique comprend la calibration de la tension en circuit ouvert (OCV) de l'électrode négative de l'élément électrochimique en réalisant :

   - le calcul d'une perte de matériau actif (LLI) et/ou d'une perte de lithium inventaire (LAM) correspondant(s) à l'estimation de la croissante de la couche de passivation (SEI) $SEI_{Growth}[N]$ et de l'estimation de perte de capacité négative $C_{neg\_loss}[N]$ ;
   - la correction de la tension en circuit ouvert (OCV) de l'électrode négative en fonction du calcul de la perte de matériau actif (LLI) et/ou de la perte de lithium inventaire (LAM).

9. Procédé selon la revendication 7 ou 8, dans lequel la détermination d'une plage de valeurs comprend pour une opération de décharge de l'élément électrochimique :

   - le calcul de la valeur $SOC_{PeakMin}[N]$ par la formule :

$$SOC_{PeakMin}[N] = 100 - 100 * (Ah_{PeakMin}[N] / Capa_{batt}[N])$$

   - le calcul de la valeur $SOC_{PeakMax}[N]$ par la formule :

$$SOC_{PeakMax}[N] = 100 - 100 * (Ah_{PeakMax}[N] / Capa_{batt}[N])$$

   et dans lequel la détermination d'une plage de valeurs comprend pour une opération de charge de l'élément électrochimique :

   - le calcul de la valeur minimale de la plage $SOC_{PeakMin}[N]$ par la formule :

$$SOC_{PeakMin}[N] = 100 * (Ah_{PeakMin}[N] / Capa_{batt}[N])$$

   - le calcul de la valeur maximale de la plage $SOC_{PeakMax}[N]$ par la formule :

$$SOC_{PeakMax}[N] = 100 * (Ah_{PeakMax}[N] / Capa_{batt}[N])$$

   où

   $Ah_{PeakMin}[N]$ est la deuxième valeur représentant quantité d'électricité ayant traversé l'élément électrochimique pour la valeur minimale du signal image de référence ;
   $Ah_{PeakMax}[N]$ est une quatrième valeur représentant une quantité d'électricité ayant traversé l'élément électrochimique pour une valeur maximale du signal image des déformations ; et
   $Capa_{batt}[N]$ est une estimation de la capacité réelle de l'élément électrochimique.

10. Procédé selon la revendication 9, dans lequel l'estimation du vieillissement de l'élément électrochimique comprend une estimation d'une croissance d'une couche de passivation (SEI) $SEI_{Growth}[N]$ et une estimation d'une perte de capacité négative $C_{neg\_loss}[N]$,
    et dans lequel la comparaison comprend en outre :

- le calcul d'une estimation de la capacité réelle de l'élément électrochimique Capa$_{batt}$[N] à l'aide de la formule :

$$\text{Capa}_{batt}[N] = \text{Capa}_{batt}[N-1] - (\text{SEI}_{Growth}[N] + C_{neg\_loss}[N])$$

où Capa$_{batt}$[N-1] est une valeur de capacité de référence ;
SEI$_{Growth}$[N] est l'estimation de la croissance de la couche de passivation (SEI) ;
C$_{neg\_loss}$[N] est l'estimation de la perte de capacité négative.

**11.** Programme d'ordinateur comprenant des instructions de code de programme pour l'exécution du procédé selon l'une des revendications 1 à 10.

**12.** Support d'information lisible par un ordinateur sur lequel est enregistré le programme d'ordinateur selon la revendication 11.

**13.** Système comprenant :

- un capteur de déformation de l'élément électrochimique ;
- une unité de gestion de l'élément électrochimique, l'unité de gestion étant en communication avec le capteur et comprenant une unité de calcul couplée à une mémoire, la mémoire stockant le programme d'ordinateur selon la revendication 11 et étant apte à stocker au moins des valeurs du signal image de référence, des valeurs du signal image calculé, et des valeurs de la comparaison.

**14.** Système selon la revendication 13, dans lequel le capteur de déformation est une jauge de contrainte qui délivre une tension formant le signal image des déformations en fonction de la quantité d'électricité traversant l'élément électrochimique dans le temps.

**15.** Ensemble comprenant :

- le système selon l'une des revendications 13 ou 14 ;
- une batterie comprenant au moins un élément électrochimique couplé avec le capteur de déformation.

**16.** Ensemble selon la revendication 15, dans lequel l'élément électrochimique est du type ayant une courbe d'état de charge (OCV) comprenant une zone plate dans laquelle la relation entre l'état de charge et/ou la tension en circuit ouvert (OCV) est non-bijective. 1

**Patentansprüche**

**1.** Verfahren zum Schätzen des Gesundheitszustands (SOH) eines elektrochemischen Elements, umfassend:

- eine Initiierung eines Lade- oder Entladevorgangs des elektrochemischen Elements;
- eine Messung von Werten, die Verformungen des elektrochemischen Elements darstellen, während der Lade- oder Entladevorgang durchgeführt wird, wobei die gemessenen Verformungswerte ein Bildsignal der Verformungen als Funktion der Menge an Elektrizität bilden, die im Lauf der Zeit durch das elektrochemische Element fließt;
- einen Vergleich zwischen dem Bildsignal der Verformungen und einem Referenzbildsignal, wobei eine oder mehrere durch den Vergleich erlangte Differenzen eine Schätzung der Alterung des elektrochemischen Elements durch eine Schätzung eines Wachstums einer Passivierungsschicht (SEI) SEIGrowth[N] und eine Schätzung eines negativen Kapazitätsverlusts C$_{neg\_loss}$[N] charakterisieren.

**2.** Verfahren nach Anspruch 1, wobei der Vergleich ferner Folgendes umfasst:

- die Berechnung einer Schätzung der tatsächlichen Kapazität des elektrochemischen Elements Capa$_{batt}$[N] mittels der Formel:

$$Capa_{batt}[N] = Capa_{batt}[N-1] - (SEI\_Growth\ [N] + C_{neg\_loss}[N])$$

wobei

$Capa_{batt}[N-1]$ ein Referenzkapazitätswert ist.

3. Verfahren nach einem der Ansprüche 1 oder 2, wobei die Schätzung des Wachstums einer Passivierungsschicht (SEI) SEIGrowth[N] durch die folgende Formel berechnet wird:

$$SEI\_Growth\ [N] = Ah_{PeakMin}[N-1] - Ah_{PeakMin}[N]$$

wobei

$Ah_{PeakMin}[N-1]$ ein erster Wert ist, der eine Menge an Elektrizität darstellt, die bei einem Minimalwert des Referenzbildsignals durch das elektrochemische Element geflossen ist;

$Ah_{PeakMin}[N]$ ein zweiter Wert ist, der eine Elektrizitätsmenge darstellt, die bei einem Minimalwert des Bildsignals der Verformungen durch das elektrochemische Element geflossen ist;

und wobei die Schätzung des negativen Kapazitätsverlusts $C_{neg\_loss}[N]$ durch die folgende Formel berechnet wird:

$$C_{neg\_loss}[N] = (Ah_{PeakMax}[N-1] - Ah_{Peak6Min}\ [N-1]) - (Ah_{PeakMax}[N] - Ah_{PeakMin}[N])$$

wobei

$Ah_{PeakMin}[N-1]$ der erste Wert ist, der eine Menge an Elektrizität darstellt, die bei dem Minimalwert des Referenzbildsignals durch das elektrochemische Element geflossen ist;

$Ah_{PeakMin}[N]$ der zweite Wert ist, der eine Menge an Elektrizität darstellt, die bei dem Minimalwert des Referenzbildsignals durch das elektrochemische Element geflossen ist;

$Ah_{PeakMax}[N-1]$ ein dritter Wert ist, der eine Menge an Elektrizität darstellt, die bei einem Maximalwert des Referenzbildsignals durch das elektrochemische Element geflossen ist;

$Ah_{PeakMax}[N]$ ein vierter Wert ist, der eine Elektrizitätsmenge darstellt, die bei einem Maximalwert des Bildsignals der Verformungen durch das elektrochemische Element geflossen ist;

4. Verfahren nach einem der Ansprüche 1 bis 3, wobei das Referenzbildsignal anhand denselben Schritten erlangt wird wie das Bildsignal, das bei einem vorherigen Lade- oder Entladevorgang berechnet wurde.

5. Verfahren nach Anspruch 4, wobei der vorherige Lade- oder Entladevorgang der erste Lade- oder Entladevorgang des elektrochemischen Elements ist.

6. Verfahren nach einem der vorherigen Ansprüche, ferner umfassend:

- eine Berechnung der zeitlichen Ableitung des Referenzbildsignals; und wobei der Vergleich Folgendes umfasst:

- den Vergleich der berechneten Ableitung mit einer Referenzableitung.

7. Verfahren zum Schätzen des Ladezustands, SOC, einer elektrochemischen Zelle, umfassend:

- eine Initiierung eines Lade- oder Entladevorgangs des elektrochemischen Elements;
- eine Messung von Werten, die Verformungen des elektrochemischen Elements darstellen, während der Lade- oder Entladevorgang durchgeführt wird, wobei die gemessenen Verformungswerte ein Bildsignal der Verformungen als Funktion der Menge an Elektrizität bilden, die im Lauf der Zeit durch das elektrochemische Element fließt;
- einen Vergleich zwischen dem Bildsignal der Verformungen und einem Referenzbildsignal, wobei eine oder mehrere durch den Vergleich erlangte Differenzen eine Schätzung der Alterung des elektrochemischen Elements charakterisieren.
- eine Bestimmung eines Wertebereichs des Ladezustands, der durch einen ersten Wert $SOC_{PeakMin}$, der den aktuellen SOC des Elements bei einem Minimalwert des Bildsignals der Verformungen darstellt, und einen zweiten Wert $SOC_{PeakMax}$, der den aktuellen SOC des Elements bei einem Maximalwert des Bildsignals der Verformungen darstellt, begrenzt ist, und außerhalb des Bereichs die Kalibrierung der Leerlaufspannung (OCV) des elektrochemischen Elements durchführbar ist.

8. Verfahren nach Anspruch 7, ferner umfassend den Schritt, der aus Folgendem besteht:

- die Kalibrierung der Leerlaufspannung (OCV) des elektrochemischen Elements;
und wobei die Kalibrierung ferner das Schätzen der Alterung des elektrochemischen Elements durch eine Schätzung einer Zunahme einer Passivierungsschicht (SEI) $SEI_{Growth}[N]$ und eine Schätzung eines negativen Kapazitätsverlusts $C_{neg\_loss}[N]$ umfasst;
und wobei die Kalibrierung der Leerlaufspannung (OCV) des elektrochemischen Elements die Kalibrierung der Leerlaufspannung (OCV) der negativen Elektrode des elektrochemischen Elements durch Durchführen von Folgendem umfasst:

- die Berechnung eines Verlusts an aktivem Material (LLI) und/oder eines Lithiuminventarverlusts (LAM), der (die) der Schätzung des Passivierungsschichtwachstums (SEI) $SEI_{Growth}[N]$ und der Schätzung des negativen Kapazitätsverlusts $C_{neg\_loss}[N]$ entspricht (entsprechen);
- die Korrektur der Leerlaufspannung (OCV) der negativen Elektrode entsprechend der Berechnung des Verlusts an aktivem Material (LLI) und/oder des Lithiuminventarverlusts (LAM).

9. Verfahren nach Anspruch 7 oder 8, wobei die Bestimmung eines Wertebereichs für einen Entladevorgang des elektrochemischen Elements Folgendes umfasst:

- die Berechnung des Werts $SOC_{PeakMin}[N]$ durch die Formel:

$$SOC_{PeakMin}[N] = 100 - 100 * (Ah_{PeakMin}[N] / Capa_{batt}[N])$$

- die Berechnung des Werts $SOC_{PeakMax}[N]$ durch die Formel:

$$Ah_{PeakMax}[N] = 100 - 100 * (Ah_{PeakMax}[N] / Capa_{batt}[N])$$

und wobei die Bestimmung eines Wertebereichs für einen Ladevorgang des elektrochemischen Elements Folgendes umfasst:

- die Berechnung des Minimalwerts des Bereichs $SOC_{PeakMin}[N]$ durch die Formel:

$$SOC_{PeakMin}[N] = 100 * (Ah_{PeakMin}[N] / Capa_{batt}[N])$$

- die Berechnung des Maximalwerts des Bereichs $SOC_{PeakMax}[N]$ durch die Formel:

$$SOC_{PeakMax}[N] = 100 * (Ah_{PeakMax}[N] / Capa_{batt}[N])$$

wobei

$Ah_{PeakMin}[N]$ der zweite Wert ist, der eine Menge an Elektrizität darstellt, die bei dem Minimalwert des Referenzbildsignals durch das elektrochemische Element geflossen ist;
$Ah_{PeakMax}[N]$ ein vierter Wert ist, der eine Elektrizitätsmenge darstellt, die bei einem Maximalwert des Bildsignals der Verformungen durch das elektrochemische Element geflossen ist; und
$Capa_{batt}[N]$ ein Schätzwert für die tatsächliche Kapazität des elektrochemischen Elements ist.

10. Verfahren nach Anspruch 9, wobei die Schätzung der Alterung des elektrochemischen Elements eine Schätzung eines Wachstums einer Passivierungsschicht (SEI) $SEI_{Growth}[N]$ und eine Schätzung eines negativen Kapazitätsverlusts $C_{neg\_loss}[N]$ umfasst,
und wobei der Vergleich ferner Folgendes umfasst:

- die Berechnung einer Schätzung der tatsächlichen Kapazität des elektrochemischen Elements Capa$_{batt}$[N] mittels der Formel:

$$\text{Capa}_{batt}[N] = \text{Capa}_{batt}[N-1] - (\text{SEI}_{Growth}[N] + C_{neg\_loss}[N])$$

wobei

Capa$_{batt}$[N-1] ein Referenzkapazitätswert ist;
SEI$_{Growth}$[N] der Schätzwert des Wachstums der Passivierungsschicht (SEI) ist;
C$_{neg\_loss}$[N] der Schätzwert des negativen Kapazitätsverlusts ist.

11. Computerprogramm, umfassend Programmcodeanweisungen zur Ausführung des Verfahrens nach einem der Ansprüche 1 bis 10.

12. Computerlesbarer Informationsträger, auf dem das Computerprogramm nach Anspruch 11 gespeichert ist.

13. System, umfassend:

- einen Sensor für die Verformung des elektrochemischen Elements;
- eine Verwaltungseinheit des elektrochemischen Elements, wobei die Verwaltungseinheit mit dem Sensor in Verbindung ist und umfassend eine mit einem Speicher gekoppelte Recheneinheit, wobei der Speicher das Computerprogramm nach Anspruch 11 speichert und in der Lage ist, zumindest Werte des Referenzbildsignals, Werte des berechneten Bildsignals und Werte des Vergleichs zu speichern.

14. System nach Anspruch 13, wobei der Verformungssensor ein Verformungsmessstreifen ist, der eine Spannung abgibt, die das Bildsignal der Verformungen als Funktion der Menge an Elektrizität bildet, die über die Zeit durch das elektrochemische Element fließt.

15. Anordnung, umfassend:

- das System nach einem der Ansprüche 13 oder 14;
- eine Batterie, umfassend mindestens ein elektrochemisches Element, das mit dem Verformungssensor gekoppelt ist.

16. Anordnung nach Anspruch 15, wobei das elektrochemische Element von dem Typ mit einer Ladezustandskurve (OCV) ist, umfassend einen flachen Bereich, in dem das Verhältnis zwischen dem Ladezustand und/oder der Leerlaufspannung (OCV) nicht-bijektiv ist.

**Claims**

1. A method for estimating the state of health (SOH) of an electrochemical element, comprising:

- an initiation of a charge or discharge operation of the electrochemical element;
- a measurement of values representing deformations of the electrochemical element while the charge or discharge operation is being performed, the measured deformation values forming a deformations image signal as a function of the quantity of electricity passing through the electrochemical element over time;
- a comparison between the deformations image signal and a reference image signal, one or more differences obtained by the comparison characterizing an estimate of the aging of the electrochemical element by an estimate of growth of a passivation layer (SEI) SEIGrowth[N] and an estimation of a negative capacity loss C$_{neg\_loss}$[N].

2. The method according to claim 1, wherein the comparison further comprises:

- the calculation of an estimate of the real capacity of the electrochemical element Capa$_{batt}$[N] by using the formula:

$$Capab_{batt}[N] = Capa_{batt}[N-1] - (SEI\_Growth\ [N] + C_{neg\_loss}[N])$$

where
$Capa_{batt}[N-1]$ is a reference capacity value.

3. The method according to one of claims 1 or 2, wherein the estimate of the growth of a passivation layer (SEI) SEIGrowth[N] is calculated by the formula:

$$SEI\_Growth\ [N] = Ah_{PeakMin}[N-1] - Ah_{PeakMin}[N]$$

where

$Ah_{PeakMin}[N-1]$ is a first value representing a quantity of electricity that has passed through the electrochemical element for a minimum value of the reference image signal;
$Ah_{PeakMin}[N]$ is a second value representing a quantity of electricity that has passed through the electrochemical element for a minimum value of the deformations image signal;
and wherein the estimate of the negative capacity loss Cneg_loss[N] is calculated by the formula:

$$Cneg\_loss[N] = (Ah_{PeakMax}[N-1] - Ah_{Peak6Min}[N-1]) - (Ah_{PeakMax}[N] - Ah_{PeakMin}[N])$$

where
$Ah_{PeakMin}[N-1]$ is the first value representing a quantity of electricity that has passed through the electrochemical element for the minimum value of the reference image signal;
$Ah_{PeakMin}[N]$ is the second value representing a quantity of electricity that has passed through the electrochemical element for the minimum value of the reference image signal;
$Ah_{PeakMax}[N-1]$ is a third value representing a quantity of electricity that has passed through the electrochemical element for a maximum value of the reference image signal;
$Ah_{PeakMax}[N]$ is a fourth value representing a quantity of electricity that has passed through the electrochemical element for a maximum value of the deformations image signal.

4. The method according to one of claims 1 to 3, wherein the reference image signal is obtained according to the same steps as the image signal calculated during a preceding charge or discharge operation.

5. The method according to claim 4, wherein the preceding charge or discharge operation is the first charge or discharge operation of the electrochemical element.

6. The method according to one of the preceding claims, further comprising:

   - a calculation of the time derivative of the reference image signal;

   and wherein the comparison comprises:

   - the comparison between the calculated derivative and a reference derivative.

7. A method for estimating the state of charge, SOC, of an electrochemical element, comprising:

   - an initiation of a charge or discharge operation of the electrochemical element;
   - a measurement of values representing deformations of the electrochemical element while the charge or discharge operation is being performed, the measured deformation values forming a deformations image signal as a function of the quantity of electricity passing through the electrochemical element over time;
   - a comparison between the deformations image signal and a reference image signal, one or more differences obtained by the comparison characterizing an estimation of the aging of the electrochemical element;
   - a determination of a range values of the state of charge, SOC, bounded by a first value $SOC_{PeakMin}$ that represents the current SOC of the element for a minimum value of the deformations image signal, and a second value $SOC_{PeakMax}$ that represents the current SOC of the element for a maximum value of the deformations image signal, and outside said range the calibration of the open circuit voltage (OCV) of the electrochemical element is achievable.

8. The method according to claim 7, further comprising the step consisting of:

- calibrating the open circuit voltage (OCV) of the electrochemical element;

and wherein the calibration further comprises the estimation of the aging of the electrochemical element by an estimate of a growth of a passivation layer (SEI) $SEI_{Growth}[N]$ and an estimate of a negative capacity loss $C_{neg\_loss}[N]$;
and wherein the calibration of the open circuit voltage (OCV) of the electrochemical element comprises the calibration of the open circuit voltage (OCV) of the negative electrode of the electrochemical element by performing:

- the calculation of a loss of active material (LLI) and/or a loss of lithium inventory (LAM) corresponding to the estimate of the growth of the passivation layer (SEI) $SEI_{Growth}[N]$ and of the estimate of the negative capacity loss $C_{neg\_loss}[N]$,
- the correction of the open circuit voltage (OCV) of the negative electrode as a function of the calculation of the loss of active material (LLI) and/or the loss of lithium inventory (LAM).

9. The method according to claim 7 or 8, wherein the determination of a range of values comprises, for a discharge operation of an electrochemical element:

- the calculation of the value $SOC_{PeakMin}[N]$ by the formula:

$$SOC_{PeakMin}[N] = 100 - 100*(Ah_{PeakMin}[N]/Capa_{batt}[N])$$

- the calculation of the value $SOC_{PeakMax}[N]$ by the formula:

$$SOC_{PeakMax}[N] = 100 - 100*(Ah_{PeakMax}[N]/Capa_{batt}[N])$$

and wherein the determination of a range of values comprises, for a charging operation of the electrochemical element:

- the calculation of the minimum value of the range $SOC_{PeakMin}[N]$ by the formula:

$$SOC_{PeakMin}[N] = 100*(Ah_{PeakMin}[N]/Capa_{batt}[N])$$

- the calculation of the maximum value of the range $SOC_{PeakMax}[N]$ by the formula:

$$SOC_{PeakMax}[N] = 100*(Ah_{PeakMax}[N]/Capa_{batt}[N]),$$

where

$Ah_{PeakMin}[N]$ is the second value representing a quantity of electricity that has passed through the electrochemical element for the minimum value of the reference image signal;
$Ah_{PeakMax}[N]$ is a fourth value representing a quantity of electricity that has passed through the electrochemical element for a maximum value of the deformations image signal; and $Capa_{batt}[N]$ is an estimate of the actual capacity of the electrochemical element.

10. The method according to claim 9, wherein the estimate of the aging of the electrochemical element comprises an estimate of a growth of a passivation layer (SEI) $SEI_{Growth}[N]$ and an estimate of a negative capacity loss $C_{neg\_loss}[N]$,

and wherein the comparison further comprises:

- the calculation of an estimate of the actual capacity of the electrochemical element $Capa_{batt}[N]$ using the formula:

$$Capa_{batt}[N] = Capa_{batt}[N-1] - (SEI_{Growth}[N] + C_{neg\_loss}[N])$$

where
$Capa_{batt}[N-1]$ is a reference capacity value;
$SEI_{Growth}[N]$ is the estimate of the growth of the passivation layer (SEI);
$C_{neg\_loss}[N]$ is the estimate of negative capacity loss.

11. A computer program comprising program code instructions for executing the method according to one of claims 1 to 10.

12. An information storage medium that is computer readable on which the computer program according to claim 11 is stored.

13. A system comprising:

    - a deformation sensor for detecting deformations of the electrochemical element,
    - a management unit for managing the electrochemical element, the management unit being in communication with the sensor and comprising a computing unit coupled to a memory storage unit, with the memory storage unit storing the computer program according to claim 11 and being able to store at least the values of the reference image signal, values of the calculated image signal, and values of the comparison.

14. The system according to claim 13, wherein the deformation sensor is a strain gauge, which delivers a voltage that forms the deformations image signal as a function of the quantity of electricity passing through the electrochemical element over time.

15. An assembly comprising:

    - the system according to one of claims 13 or 14;
    - a battery comprising at least one electrochemical element coupled with the deformation sensor.

16. The assembly according to claim 15, wherein the electrochemical element is of the type that has a state of charge curve (OCV) comprising a flat zone wherein the relationship between the state of charge and/or the open circuit voltage (OCV) is non-bijective.

[Fig. 1]

[Fig. 2]

[Fig. 3]

```
┌─────────────────────────────┐
│  Mesure de la tension image │
│  de la déformation élément  │ ⟿ S300
└─────────────────────────────┘
              │
              │ V_deformation
              ▼
┌─────────────────────────────┐
│  Dérivée du signal de       │
│  déformation en fonction    │ ⟿ S310
│  du temps                   │
└─────────────────────────────┘
              │
              │ dV_deformation/dt
              ▼
         ◇─────────◇
        ╱ Détection  ╲      Non
       ◇  PeakMin ?    ◇────────► ⟿ S322
        ╲           ╱
         ◇─────────◇
              │ Oui    ⟿ S320
              ▼
┌─────────────────────────────┐
│  Estimation de la croissance│ ⟿ S330
│  de SEI apparente           │
└─────────────────────────────┘
              │
              ▼
         ◇─────────◇
        ╱ Détection  ╲      Non
       ◇  PeakMax ?    ◇────────► ⟿ S342
        ╲           ╱
         ◇─────────◇
              │ Oui    ⟿ S340
              ▼
┌─────────────────────────────┐
│  Estimation de la perte de  │ ⟿ S350
│  capacité de la négative    │
└─────────────────────────────┘
              │
              ▼
┌─────────────────────────────┐
│  Estimation de la capacité  │ ⟿ S360
│  batterie                   │
└─────────────────────────────┘
```

[Fig. 4]

[Fig. 5]

```
┌─────────────────────────────────────┐
│  Mesure de la tension image de la    │
│       déformation élément            │  ～ S500
└─────────────────────────────────────┘
                │
                │ V$_{deformation}$
                ▼
┌─────────────────────────────────────┐
│  Dérivée du signal de déformation en │
│         fonction du temps            │  ～ S510
└─────────────────────────────────────┘
                │
                │ dV$_{deformation}$/dt
                ▼
        S520 ～        ◇
              ╱   SOH mis à jour ?   ╲ ──────┐ ～ S522
              ╲                      ╱  Non   │
                     ◇                        │
                │ Oui                         │
                ▼                             ▼
┌──────────────────────────┐   ┌──────────────────────────────────┐
│  Calibration de l'OCV de │   │  Calibration des points de repères│
│   l'électrode négative   │   │  SOC$_{PeakMin}$[N] = f(AhDch$_{PeakMin}$[N]) │
│                          │   │  SOC$_{PeakMax}$[N] = f(AhDch$_{PeakMax}$[N]) │
└──────────────────────────┘   └──────────────────────────────────┘
         ～ S540                          ～ S530
          │
          ▼
┌──────────────────────────┐
│  Calibration de l'OCV    │
│        élément           │  ～ S550
└──────────────────────────┘
```

[Fig. 6]

```
S600 ～                    S610 ～                S620 ～
┌──────────┐           ◇                  ┌──────────────────────┐
│          │          ╱ ╲  Non            │                      │
│ Mesure   │ V$_{element}$ ╱   ╲ ──────────→     │ Calibration du SOC   │
│ tension  │─────────→╲ Zone 1 ╱                 │ sur la tension       │
│ élément  │          ╲ou Zone╱  Oui             │ SOC = f(OCV$_{cell}$[N]) │
│          │           ╲ 4 ? ╱ ──────────→       │                      │
└──────────┘            ◇                  └──────────────────────┘
```

28

EP 3 899 562 B1

[Fig. 7]

[Fig. 8]

Cell deformation for discharges at C-rate from 3.8V to 2.7V at +25°C

[Fig. 9]

|  | Cell deformation (C rate) | | | | |
|---|---|---|---|---|---|
|  | PeakMin (Ah) | PeakMax (Ah) | SEI Growth | CapaNeg Loss | Capa Loss |
| Initial State | 9 | 19,3 | - | - | - |
| After 1st ageing | 4,4 | 12 | 4,6 | 2,7 | 7,3 |
| After 2nd ageing | 4,5 | 12,7 | -0,1 | -0,6 | -0,7 |
| After 3rd ageing | 2,9 | 11,6 | 1,6 | -0,5 | 1,1 |

[Fig. 10]

|  | Cell deformation (C rate) | | | | |
|---|---|---|---|---|---|
|  | AhDch$_{PeakMin}$ (Ah) | AhDch$_{PeakMax}$ (Ah) | Capa$_{Batt}$ (Ah) | SOC$_{PeakMin}$ (%) | SOC$_{PeakMax}$ (%) |
| Initial State | 9 | 19,3 | 31,51 | 71,4 | 38,7 |
| After 1st ageing | 4,4 | 12 | 24,21 | 81,8 | 50,4 |
| After 2nd ageing | 4,5 | 12,7 | 24,91 | 81,9 | 49,0 |
| After 3rd ageing | 2,9 | 11,6 | 23,81 | 87,8 | 51,3 |

[Fig. 11]

Cell deformation for discharges at C-rate from 3.8V to 2.7V at +25°C

[Fig. 12]

[Fig. 13]

[Fig. 14]

[Fig. 15]

[Fig. 16]

[Fig. 17]

[Fig. 18]

## RÉFÉRENCES CITÉES DANS LA DESCRIPTION

**Documents brevets cités dans la description**

- DE 102012208509
- EP 2269954 A
- US 2013229154 A1
- EP 2144075 A
- EP 2239826 A
- EP 2309615 A